# EUROPEAN PATENT APPLICATION

(11) **EP 4 830 919 A1**
(43) Date of publication of application: **28.10.2026**
(21) Application number: 25844441.3
(22) Date of filing: 30.06.2025
(51) Int. Cl.: B32B 27/32, B29C 65/02, B32B 9/00, B32B 27/34, B65D 65/40, C23C 14/08

(54) **POLYMER FILM, BARRIER FILM, LAMINATE, AND PACKAGING BAG**

(30) Priority: 23.07.2024 JP 2024118262; 31.01.2025 JP 2025015282; 02.04.2025 JP 2025061481
(71) Applicant: Dai Nippon Printing Co., Ltd., Tokyo 162-8001 (JP)
(72) Inventor: YUNO Masato, Tokyo 162-8001 (JP); MORIMOTO Taro, Tokyo 162-8001 (JP); ONODA Junna, Tokyo 162-8001 (JP); SUZUKI Tsuyoshi, Tokyo 162-8001 (JP); MATSUI Shigeki, Tokyo 162-8001 (JP)
(74) Representative: Müller-Boré & Partner Patentanwälte PartG mbB
(86) International application number: PCT/JP2025/023521
(87) International publication number: WO 2026/023346

(57) **Abstract**

A polymer film 10 of the present disclosure includes a first resin layer 11, a second resin layer 12, and a third resin layer 13 in this order, wherein the first resin layer 11 constitutes one outermost layer of the polymer film 10, the first resin layer 11 contains a polyamide resin, a resin constituting the first resin layer 11 has no cold crystallization temperature and has a glass transition temperature of 155°C or lower, the second resin layer 12 contains an acid-modified product of polypropylene, and the third resin layer 13 contains homopolypropylene.

## Description

### Technical Field

The present disclosure relates to a polymer film, a barrier film, a laminate, and a packaging bag.

### Background Art

The flexible packaging materials are generally formed by laminating a plurality of films. A film made of polyester such as polyethylene terephthalate is used in order to impart strength and heat resistance to the packaging material, a film made of polyamide 6 is used in order to impart pinhole resistance, and a film made of polypropylene is used in order to impart strength and water vapor barrier properties. These films are usually biaxially stretched to impart printability.

Such a biaxially oriented film is printed if necessary, and an unstretched film made of polyethylene or polypropylene which is not stretched is usually laminated on the printed surface side. A packaging bag is produced from the laminate composed of the plurality of films by heat-sealing the inner sides of the unstretched film made of polyethylene or polypropylene.

In order to impart barrier properties to the packaging bag, an aluminum foil, a film vapor-deposited with aluminum, alumina or silicon oxide, a layer made of an ethylene-vinyl alcohol copolymer or polyvinyl alcohol, or the like is provided between the biaxially oriented film and the unstretched film.

The flexible packaging material satisfies required performance and can be used as a packaging material for packaging various contents by laminating a plurality of different materials. In recent years, in order to reduce the emission of carbon dioxide, which is considered to be a major cause of global warming, such flexible packaging materials are also required to be recycled. Since it is very difficult to recycle packaging materials made of different materials, the shift to mono-materials made of a single material as a means for recycling flexible packaging materials has become a growing trend. As a material for the shift to mono-materials, polyolefin which is easily recycled is considered to be preferable.

The packaging bag for heat sterilization is subjected to a boiling treatment or a retort treatment after the packaging bag is filled with contents and sealed. Alternatively, heated contents may be filled. Since the packaging bag is heat-treated in such treatments, it is appropriate to use polypropylene, which has higher heat resistance than polyethylene, for the unstretched film to be sealed by heat-sealing. When polypropylene is used as a constituent material of the packaging material, suitability as a packaging material such as printability, barrier properties, heat sealability and lamination suitability is imparted to a film made of polypropylene. The printing is performed on a biaxially oriented polypropylene film having strength. The heat-sealing is performed using an unstretched polypropylene film.

In order to impart barrier properties to the packaging material while enabling recycling, it is considered appropriate to use a polypropylene film on which alumina or silicon oxide is vapor-deposited. Therefore, as a film for a mono-material packaging material, a film obtained by vapor-depositing an inorganic oxide such as alumina or silicon oxide on a polypropylene film has been proposed.

However, even when the inorganic oxide is vapor-deposited on the surface of the polypropylene film, the barrier performance may not be exhibited due to fine irregularities at the surface of the oriented polypropylene film. In addition, the adhesion strength between the vapor-deposited inorganic oxide and the surface of the polypropylene film is low, and the physical properties of the laminate may be insufficient. Therefore, in order to compensate for the disadvantage of the polypropylene film with respect to vapor deposition, it has been proposed to provide a layer containing a resin material having a melting point of 180°C or higher on one surface of a biaxially oriented polypropylene film and to vapor-deposit an inorganic oxide on the surface of this layer (Patent Literature 1).

### Citation List

### Patent Literature

PTL 1: Japanese Unexamined Patent Application Publication No. 2022-7964

### Summary of Invention

### Technical Problem

PTL 1 discloses polyamide as the resin material having a melting point of 180°C or higher. However, some polyamides, even when formed into a film, are broken by subsequent stretching. There has been a demand for a polymer film having film-forming properties to such an extent that the film is not broken even when stretched.

In addition, some polymer films in which a layer containing polyamide is provided on one surface of a polypropylene film are significantly curled by heat sterilization. There has been a demand for a polymer film which is less likely to be curled even when heated.

In addition, when heat sterilization is performed on the packaging bag, the film constituting the packaging bag expands or contracts, stress is generated between the layers, and delamination may occur between the layers of the film due to heating in a state in which stress acts between the layers. In polymer films in which a layer containing a polyamide resin is provided on one surface of a polypropylene film, suppression of delamination has been in demand.

Therefore, an object of the present disclosure is to provide a polymer film from which a barrier film can be produced, wherein the barrier film is excellent in film-forming properties, heat resistance, and recyclability, can suppress delamination, and is excellent in gas barrier properties.

Another object of the present disclosure is to provide a barrier film, a laminate and a packaging bag using the polymer film.

### Solution to Problem

The present inventors have found that when a layer having a glass transition temperature of a certain level or lower is used as the polyamide-containing layer provided on one surface of the polypropylene film, the polyamide-containing layer is not broken even when the film is stretched at a low temperature, and thus the film-forming properties are improved.

In addition, the present inventors have found that when a layer in which a cold crystallization temperature is not observed in differential scanning calorimetry (DSC) is used as the polyamide-containing layer provided on one surface of the polypropylene film, the polyamide-containing layer is not crystallized by natural cooling after heating and is less likely to contract, and thus curling can be suppressed.

In addition, the present inventors have paid attention to the fact that an acid-modified product of polypropylene is a polypropylene-based resin having excellent adhesion properties, and have found that when a layer containing the acid-modified product of polypropylene is provided between a polypropylene film and a polyamide-containing layer, delamination can be suppressed without impairing recyclability.

The present disclosure has been completed through further studies based on these findings.

The present disclosure includes the following embodiments.
<1> A polymer film including a first resin layer, a second resin layer, and a third resin layer in this order,
   wherein the first resin layer constitutes one outermost layer of the polymer film,
   the first resin layer includes a polyamide resin,
   a resin constituting the first resin layer does not have a cold crystallization temperature,
   a glass transition temperature of the resin constituting the first resin layer is 155°C or less,
   the second resin layer includes an acid-modified product of polypropylene, and
   the third resin layer includes homopolypropylene.
<2> The polymer film according to <1>, wherein the polyamide resin included in the first resin layer is of one type.
<3> The polymer film according to <2>, wherein a content of the polyamide resin in the first resin layer is 70 mass% or more.
<4> The polymer film according to <1>, wherein the polyamide resin included in the first resin layer is of two types, a first polyamide and a second polyamide,
   the first polyamide is an aromatic polyamide or an alicyclic polyamide, and
   the second polyamide is an aromatic polyamide, an alicyclic polyamide or an aliphatic chain polyamide.
<5> The polymer film according to <4>, wherein a content of the first polyamide in the first resin layer is 50 mass% or more and 95 mass% or less.
<6> The polymer film according to <4> or <5>, wherein a content of the second polyamide in the first resin layer is 5 mass% or more and 50 mass% or less.
<7> The polymer film according to any one of <1> to <6>, wherein the resin constituting the first resin layer has no melting point.
<8> The polymer film according to any one of <1> to <7>, wherein a content of polypropylene in the polymer film is 70 mass% or more.
<9> The polymer film according to any one of <1> to <8>, wherein a thickness of the third resin layer is largest among thicknesses of the first resin layer, the second resin layer, and the third resin layer, and
   thicknesses of layers constituting the polymer film satisfy the following formulae (1) and (2): $Thickness of first resin layer \leq \left(Thickness of polymer film\right) / 10$ (1) $Thickness of second resin layer \leq \left(Thickness of polymer film\right) / 5$ (2)
<10> The polymer film according to any one of <1> to <9>, including a fourth resin layer on a side of the third resin layer opposite the second resin layer,
   wherein the fourth resin layer includes a copolymer of propylene and an olefin other than propylene.
<11> A barrier film including the polymer film according to any one of <1> to <10> and a vapor deposition film containing an inorganic oxide,
   wherein the vapor deposition film is provided on a side of the first resin layer.
<12> The barrier film according to <11>, further including a barrier coat layer on a side of the vapor deposition film.
<13> A laminate including the barrier film according to <11> or <12> and a heat sealant film.
<14> The laminate according to <13>, further including a polypropylene base film.
<15> A packaging bag including the laminate according to <13> or <14>.

### Advantageous Effects of Invention

The present disclosure can provide a polymer film from which a barrier film can be produced, wherein the barrier film is excellent in film-forming properties, heat resistance, and recyclability, can suppress delamination, and is excellent in gas barrier properties.

In addition, the present disclosure can provide a barrier film, a laminate and a packaging bag using the polymer film.

### Brief Description of Drawings

[Fig. 1] Fig. 1 is a schematic cross-sectional view showing an embodiment of a polymer film according to the present disclosure.
[Fig. 2] Fig. 2 is a schematic cross-sectional view showing another embodiment of the polymer film according to the present disclosure.
[Fig. 3] Fig. 3 is a schematic cross-sectional view showing an embodiment of a barrier film according to the present disclosure.
[Fig. 4] Fig. 4 is a schematic cross-sectional view showing another embodiment of the barrier film according to the present disclosure.
[Fig. 5] Fig. 5 is a schematic cross-sectional view in which a barrier coat layer is provided in an embodiment of the barrier film according to the present disclosure.
[Fig. 6] Fig. 6 is a schematic cross-sectional view showing an embodiment of a laminate according to the present disclosure.
[Fig. 7] Fig. 7 is a schematic cross-sectional view showing another embodiment of the laminate according to the present disclosure.

### Description of Embodiments

In the present specification, in a case where a plurality of upper limit value candidates and a plurality of lower limit value candidates are listed for a certain parameter, the numerical range of the parameter may be defined by combining any one upper limit value candidate and any one lower limit value candidate. As an example, a description "the parameter B is preferably A1 or more, more preferably A2 or more, and further preferably A3 or more, and is preferably A4 or less, more preferably A5 or less, and further preferably A6 or less" will be described. In this example, the numerical range of the parameter B may be A1 or more and A4 or less, A1 or more and A5 or less, A1 or more and A6 or less, A2 or more and A4 or less, A2 or more and A5 or less, A2 or more and A6 or less, A3 or more and A4 or less, A3 or more and A5 or less, or A3 or more and A6 or less.

### (Polymer film)

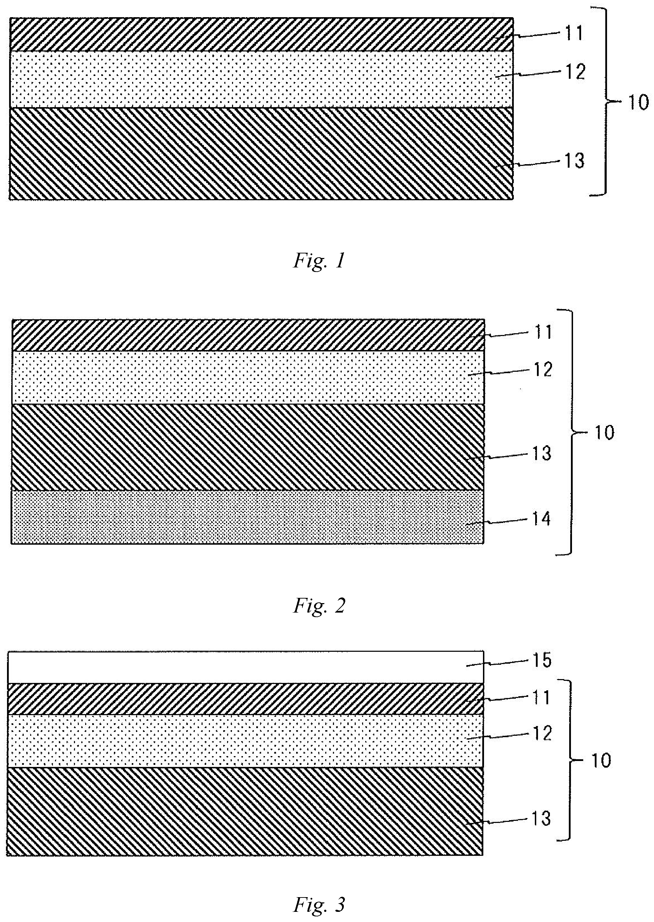

A schematic cross-sectional view of a polymer film 10 according to an embodiment of the present disclosure is shown in Fig. 1. The polymer film 10 includes a first resin layer 11, a second resin layer 12, and a third resin layer 13 in this order. The first resin layer 11 constitutes one outermost layer of the polymer film 10. The third resin layer 13 constitutes the other outermost layer of the polymer film 10.

A schematic cross-sectional view of a polymer film 10 according to another embodiment of the present disclosure is shown in Fig. 2. The polymer film 10 includes a first resin layer 11, a second resin layer 12, a third resin layer 13, and a fourth resin layer 14 in this order. The first resin layer 11 constitutes one outermost layer of the polymer film 10. The fourth resin layer 14 constitutes the other outermost layer of the polymer film 10.

As shown in Fig. 3, a vapor deposition film 15 is provided on the first resin layer 11 side of the polymer film 10 of the present disclosure to obtain a barrier film.

Hereinafter, each layer included in the polymer film 10 of the present disclosure will be described.

### (First resin layer)

The first resin layer contains a polyamide resin.

The first resin layer can include one type or two or more types of polyamide resins.

The polyamide resin content in the first resin layer is preferably more than 50 mass%, more preferably 60 mass% or more, still more preferably 70 mass% or more, particularly preferably 80 mass% or more, 85 mass% or more, 90 mass% or more, or 95 mass% or more.

Hereinafter, a raw material monomer from which a constitutional unit contained in the polyamide resin can be derived will be described, and then specific polyamide resins will be described. Examples of the raw material monomer include lactams, aminocarboxylic acids, diamines, and dicarboxylic acids. The polyamide resin is obtained by, for example, ring-opening polymerization of a lactam, polycondensation of an aminocarboxylic acid, polycondensation of a diamine and a dicarboxylic acid, or a combination thereof.

Examples of the lactam include γ-butyrolactam, δ-valerolactam, ε-caprolactam, enantholactam, undecanelactam, and dodecanelactam. Among these, ε-caprolactam, enantholactam, undecanelactam and dodecanelactam are preferred. The number of carbon atoms of the lactam is, for example, 4 or more and 12 or less.

Examples of the aminocarboxylic acid include 6-aminocaproic acid, 7-aminoheptanoic acid, 9-aminononanoic acid, 11-aminoundecanoic acid, and 12-aminododecanoic acid. Of these, 6-aminocaproic acid, 11-aminoundecanoic acid and 12-aminododecanoic acid are preferred. The number of carbon atoms of the aminocarboxylic acid is, for example, 6 or more and 12 or less.

Examples of the diamine include aliphatic diamines such as aliphatic chain diamines and alicyclic diamines, and aromatic diamines. The number of carbon atoms of such an aliphatic diamine is, for example, 2 or more and 20 or less, and preferably 4 or more and 12 or less.

Examples of the aliphatic chain diamines include aliphatic linear diamines and aliphatic branched diamines, for example, ethylenediamine, tetramethylenediamine, pentamethylenediamine, hexamethylenediamine, heptamethylenediamine, octamethylenediamine, nonamethylenediamine, decamethylenediamine, undecamethylenediamine, dodecamethylenediamine, tridecanediamine, tetradecanediamine, pentadecanediamine, hexadecanediamine, heptadecanediamine, octadecanediamine, nonadecanediamine, eicosanediamine, 2-methyl-1,5-pentanediamine, 2-methyl-1,8-octanediamine and 2,2,4-/2,4,4-trimethylhexamethylenediamine.

Examples of the alicyclic diamines include 1,3-/1,4-diaminocyclohexane, bis(4-aminocyclohexyl)methane, bis(4-aminocyclohexyl)propane, bis(3-methyl-4-aminocyclohexyl)methane, (3-methyl-4-aminocyclohexyl)propane, 1,3-/1,4-bis(aminomethyl)cyclohexane, 5-amino-2,2,4-trimethyl-1-cyclopentanemethylamine, 5-amino-1,3,3-trimethylcyclohexanemethylamine, 4,4'-methylenebis(2-methylcyclohexylamine), norbornanedimethyleneamine, bis(aminomethyl)decalin and bis(aminomethyl)tricyclodecane.

Among the aliphatic diamines, aliphatic chain diamines are preferable, aliphatic linear diamines are more preferable, tetramethylenediamine, pentamethylenediamine, hexamethylenediamine, nonamethylenediamine, decamethylenediamine, and dodecamethylenediamine are still more preferable, and hexamethylenediamine is particularly preferable.

Examples of the aromatic diamines include phenylenediamines such as p-phenylenediamine and m-phenylenediamine; xylylenediamines such as p-xylylenediamine and m-xylylenediamine; tolylenediamines such as 2,4-tolylenediamine and 2,6-tolylenediamine; diaminonaphthalenes such as 1,4-diaminonaphthalene, 1,8-diaminonaphthalene, 2,3-diaminonaphthalene and 2,6-diaminonaphthalene; diaminodiphenylmethane compounds such as 3,3'-diaminodiphenylmethane, 3,4'-diaminodiphenylmethane, 4,4'-diaminodiphenylmethane, 4,4'-diamino-3,3'-dimethyldiphenylmethane, 4,4'-diamino-3,3'-diethyldiphenylmethane, 4,4'-diamino-3,3',5,5'-tetramethyldiphenylmethane, 4,4'-diamino-3,3',5,5'-tetraethyldiphenylmethane and 4,4'-diamino-3,3'-dimethyl-5,5'-diethyldiphenylmethane; and bis(aminophenyl) propane-based compounds such as 2,2'-bis(3-aminophenyl)propane, 2,2'-bis(4-aminophenyl)propane, 2,2'-bis(4-amino-3-methylphenyl)propane, 2,2'-bis(4-amino-3-ethylphenyl)propane, 2,2'-bis(4-amino-3,5-dimethylphenyl)propane, 2,2'-bis(4-amino-3,5-diethylphenyl)propane and 2,2'-bis(4-amino-3-methyl-5-ethylphenyl)propane.

Among the aromatic diamines, xylylenediamine is preferable, p-xylylenediamine and m-xylylenediamine are more preferable, and m-xylylenediamine is still more preferable.

Examples of the dicarboxylic acid include aliphatic dicarboxylic acids such as aliphatic chain dicarboxylic acids and alicyclic dicarboxylic acids, and aromatic dicarboxylic acids. The number of carbon atoms of such an aliphatic dicarboxylic acid is, for example, 2 or more and 20 or less, and preferably 6 or more and 12 or less.

Examples of the aliphatic chain dicarboxylic acids include aliphatic linear dicarboxylic acids and aliphatic branched dicarboxylic acids, for example, oxalic acid, malonic acid, succinic acid, glutaric acid, adipic acid, pimelic acid, suberic acid, azelaic acid, sebacic acid, undecanedioic acid, dodecanedioic acid, tridecanedioic acid, tetradecanedioic acid, pentadecanedioic acid, hexadecanedioic acid, octadecanedioic acid and eicosanedioic acid.

Examples of the alicyclic dicarboxylic acids include 1,3-/1,4-cyclohexanedicarboxylic acid, dicyclohexanemethane-4,4'-dicarboxylic acid, and norbornanedicarboxylic acid.

Among the aliphatic dicarboxylic acids, aliphatic chain dicarboxylic acids are preferable, aliphatic linear dicarboxylic acids are more preferable, adipic acid, azelaic acid, sebacic acid, undecanedioic acid, and dodecanedioic acid are still more preferable, and adipic acid is particularly preferable.

Examples of the aromatic dicarboxylic acids include phthalic acid compounds such as isophthalic acid, terephthalic acid and orthophthalic acid; naphthalenedicarboxylic acids such as 1,2-naphthalenedicarboxylic acid, 1,3-naphthalenedicarboxylic acid, 1,4-naphthalenedicarboxylic acid, 1,5-naphthalenedicarboxylic acid, 1,6-naphthalenedicarboxylic acid, 1,7-naphthalenedicarboxylic acid, 1,8-naphthalenedicarboxylic acid, 2,3-naphthalenedicarboxylic acid, 2,6-naphthalenedicarboxylic acid and 2,7-naphthalenedicarboxylic acid; 4,4'-biphenyldicarboxylic acid; and diphenylmethanedicarboxylic acids such as diphenylmethane-2,4-dicarboxylic acid, diphenylmethane-3,3'-dicarboxylic acid, diphenylmethane-3,4'-dicarboxylic acid and diphenylmethane-4,4'-dicarboxylic acid.

Among the aromatic dicarboxylic acids, phthalic acid compounds are preferable, and isophthalic acid and terephthalic acid are more preferable.

The polyamide resin may be, for example, an aliphatic polyamide or an aromatic polyamide.

The aliphatic polyamide may be a polyamide resin composed of one type of lactam or one type of aminocarboxylic acid.

The aliphatic polyamide may be a polyamide resin composed of two or more monomers selected from lactams and aminocarboxylic acids.

The aliphatic polyamide may be a polyamide resin composed of a combination of one or two or more aliphatic diamines and one or two or more aliphatic dicarboxylic acids.

The aliphatic polyamide may be a polyamide resin composed of a combination of a lactam and/or an aminocarboxylic acid, an aliphatic diamine, and an aliphatic dicarboxylic acid.

The aliphatic polyamide may be an aliphatic chain polyamide having no cyclic structure in the molecule.

The aliphatic polyamide may be an alicyclic polyamide having a cyclic structure in the molecule.

In the following examples, polyamide is also referred to as "PA".

Specific examples of the aliphatic chain polyamide include polycaprolactam (PA6), polyenantholactam (PA7), polyundecanelactam (PA11), polylauryllactam (PA12), polyhexamethylene adipamide (PA66), polytetramethylene dodecamide (PA412), polypentamethylene azelamide (PA59), polypentamethylene sebacamide (PA510), polypentamethylene dodecamide (PA512), polyhexamethylene azelamide (PA69), polyhexamethylene sebacamide (PA610), polyhexamethylene dodecamide (PA612), polynonamethylene adipamide (PA96), polynonamethylene azelamide (PA99), polynonamethylene sebacamide (PA910), polynonamethylene dodecamide (PA912), polydecamethylene adipamide (PA106), polydecamethylene azelamide (PA109), polydecamethylene decamide (PA1010), polydecamethylene dodecamide (PA1012), polydodecamethylene adipamide (PA126), polydodecamethylene azelamide (PA129), polydodecamethylene sebacamide (PA1210), polydodecamethylene dodecamide (PA1212), a caprolactam/hexamethylenediamine-adipic acid copolymer (PA6/66), a caprolactam/hexamethylenediamine-azelaic acid copolymer (PA6/69), a caprolactam/hexamethylenediamine-sebacic acid copolymer (PA6/610), a caprolactam/hexamethylenediamine-undecanoic acid copolymer (PA6/611), a caprolactam/hexamethylenediamine-dodecanoic acid copolymer (PA6/612), a caprolactam/aminoundecanoic copolymer (PA6/11), a caprolactam/lauryllactam copolymer (PA6/12), a caprolactam/hexamethylenediamine-adipic acid/lauryllactam copolymer (PA6/66/12), a caprolactam/hexamethylenediamine-adipic acid/hexamethylenediamine-sebacic acid copolymer (PA6/66/610), and a caprolactam/hexamethylenediamine-adipic acid/hexamethylenediamine-dodecanedicarboxylic acid copolymer (PA6/66/612).

Examples of the alicyclic polyamide include a copolymer of 4,4'-methylenebis(2-methylcyclohexylamine) and dodecanedioic acid (PA MACM12), a copolymer of 4,4'-methylenebis(2-methylcyclohexylamine), 4,4'-methylenebis(cyclohexylamine) and dodecanedioic acid (PA MACM12/PACM12), a copolymer of 4,4'-methylenebis(2-methylcyclohexylamine), isophthalic acid and dodecanedioic acid (PA MACMI/12), a copolymer of 4,4'-methylenebis(2-methylcyclohexylamine), isophthalic acid, terephthalic acid and dodecanedioic acid (PA MACMI/MACMT/12), and a copolymer of 4,4'-methylenebis(2-methylcyclohexylamine) and tetradecanedioic acid (PA MACM14).

As the aliphatic polyamide, crystalline aliphatic polyamides such as PA6, PA11, PA12, PA66, PA610, PA612, PA6/66 and PA6/66/12 are preferred from the viewpoint of improving physical properties such as abrasion resistance, cold resistance, impact resistance and oil resistance.

The melting point of such a crystalline aliphatic polyamide is preferably 170°C or higher, and more preferably 180°C or higher. The melting point of the crystalline aliphatic polyamide is preferably 300°C or lower, more preferably 250°C or lower, still more preferably 230°C or lower, yet still more preferably 220°C or lower, particularly preferably 215°C or lower or 210°C or lower. In the present disclosure, the melting point is obtained by differential scanning calorimetry (DSC) described later. When the melting point is low, for example, in the case where polypropylene and the crystalline aliphatic polyamide are co-extruded to form a co-extruded resin film, the difference in melting point between the polypropylene and the crystalline aliphatic polyamide becomes small, so that the formability can be improved.

For example, the melting point of the crystalline aliphatic polyamide is preferably 170°C or more and 300°C or less, more preferably 170°C or more and 250°C or less, still more preferably 170°C or more and 230°C or less, further more preferably 170°C or more and 220°C or less, particularly preferably 180°C or more and 215°C or less, or 180°C or more and 210°C or less.

The aromatic polyamide is a polyamide resin having a constitutional unit derived from an aromatic diamine and a constitutional unit derived from an aliphatic dicarboxylic acid, a polyamide resin having a constitutional unit derived from an aliphatic diamine and a constitutional unit derived from an aromatic dicarboxylic acid, or a polyamide resin having a constitutional unit derived from an aromatic diamine and a constitutional unit derived from an aromatic dicarboxylic acid. Examples thereof include a polyamide resin composed of an aromatic diamine and an aliphatic dicarboxylic acid, a polyamide resin composed of an aliphatic diamine and an aromatic dicarboxylic acid, and a polyamide resin composed of an aromatic diamine and an aromatic dicarboxylic acid.

In the aromatic polyamide composed of an aromatic diamine and an aliphatic dicarboxylic acid, it is not necessary that all the diamines are aromatic diamines, and the aromatic polyamide may further have a constitutional unit derived from an aliphatic diamine. In the aromatic polyamide composed of an aliphatic diamine and an aromatic dicarboxylic acid, it is not necessary that all the dicarboxylic acids are aromatic dicarboxylic acids, and the aromatic polyamide may further have a constitutional unit derived from an aliphatic dicarboxylic acid. In the polyamide resin having a constitutional unit derived from an aromatic diamine and a constitutional unit derived from an aromatic dicarboxylic acid, it is not necessary that all the diamines are aromatic diamines, and the polyamide resin may further have a constitutional unit derived from an aliphatic diamine. In the polyamide resin having a constitutional unit derived from an aromatic diamine and a constitutional unit derived from an aromatic dicarboxylic acid, it is not necessary that all the dicarboxylic acids are aromatic dicarboxylic acids, and the polyamide resin may further have a constitutional unit derived from an aliphatic dicarboxylic acid. These aromatic polyamides may further have a constitutional unit derived from a lactam and/or an aminocarboxylic acid.

Specific examples of the aromatic polyamide include polyhexamethylene terephthalamide (PA6T), polyhexamethylene isophthalamide (PA6I), polynonamethylene terephthalamide (PA9T), a polyhexamethylene adipamide/polyhexamethylene terephthalamide copolymer (PA66/6T), a polyhexamethylene adipamide/polyhexamethylene isophthalamide copolymer (PA66/6I), a polyhexamethylene terephthalamide/polycaproamide copolymer (PA6T/6), a polyhexamethylene isophthalamide/polycaproamide copolymer (PA6I/6), a polyhexamethylene terephthalamide/polydodecamide copolymer (PA6T/12), a polyhexamethylene isophthalamide/polyhexamethylene terephthalamide copolymer (PA6I/6T), a polyhexamethylene terephthalamide/poly(2-methylpentamethylene terephthalamide) copolymer (PA6T/M5T), a polyhexamethylene adipamide/polyhexamethylene terephthalamide/polyhexamethylene isophthalamide copolymer (PA66/6T/6I), a polyhexamethyleneadipamide/polycaproamide/polyhexamethyleneisophthalamide copolymer (PA66/6/6I), a polymetaxylylene adipamide (PAMXD6), polymetaxylylene isophthalamide (PAMXDI) and a polymetaxylylene adipamide/polymetaxylylene isophthalamide copolymer (PAMXD6I). Among these, PA6I/6T, PAMXD6, PAMXDI and PAMXD6I are preferable, and PA6I/6T is more preferable.

The aromatic polyamide is preferred as the gas barrier resin.

The aromatic polyamide may be an amorphous aromatic polyamide such as PA6I/6T, or a crystalline aromatic polyamide such as PA6T, PA9T, PA6I, or PAMXD6. Among these, amorphous aromatic polyamides are preferable from the viewpoint of gas barrier properties and transparency.

Specific examples of the amorphous aromatic polyamides include a copolymer of hexamethylenediamine and isophthalic acid, a copolymer of m-xylylenediamine and isophthalic acid, a copolymer of hexamethylenediamine with dicarboxylic acids having a molar ratio of isophthalic acid/terephthalic acid of 7/3, a copolymer of 1,6-hexanediamine with dicarboxylic acids having a molar ratio of isophthalic acid/terephthalic acid of 1/1, a copolymer of m-xylylenediamine with dicarboxylic acids having a molar ratio of adipic acid/isophthalic acid of 1/1, a copolymer of 2-methyl-1,5-pentanediamine with dicarboxylic acids having a molar ratio of isophthalic acid/terephthalic acid of 7/3, and a copolymer of 2,2,4-trimethylhexamethylenediamine and terephthalic acid (PA NDT/INDT).

Specific examples of the crystalline aromatic polyamide include a copolymer of m-xylylenediamine and adipic acid, a copolymer of m-xylylenediamine with dicarboxylic acids having a molar ratio of adipic acid/isophthalic acid of 93/7, and a copolymer of m-xylylenediamine with dicarboxylic acids having a molar ratio of adipic acid/isophthalic acid of 8/2.

The amorphous polyamide means a polyamide having no definite melting point, and specifically means a polyamide having an enthalpy of fusion ΔHm of 5 J/g or less, preferably 3 J/g or less, more preferably 1 J/g or less. The enthalpy of fusion is obtained by differential scanning calorimetry (DSC) in accordance with JIS K 7121:2012 and JIS K 7122:2012.

The amorphous aromatic polyamide is preferably an aromatic polyamide having two or more types of constitutional units derived from aromatic dicarboxylic acids, and more preferably a polyamide having a constitutional unit derived from isophthalic acid and a constitutional unit derived from terephthalic acid as dicarboxylic acid components, and a constitutional unit derived from an aliphatic diamine as a diamine component (hereinafter, also referred to as "polyamide (a)").

In the polyamide (a), the ratio of the constitutional unit derived from isophthalic acid in 100 mol% of the constitutional units derived from dicarboxylic acids is preferably 40 mol% or more, and more preferably 50 mol% or more. In the polyamide (a), the ratio of the constitutional unit derived from isophthalic acid in 100 mol% of the constitutional units derived from dicarboxylic acids is preferably 98 mol% or less, and more preferably 80 mol% or less. For example, in the polyamide (a), the ratio of the constitutional unit derived from isophthalic acid in 100 mol% of the constitutional units derived from dicarboxylic acids is preferably 40 mol% or more and 98 mol% or less, and more preferably 50 mol% or more and 80 mol% or less.

In the polyamide (a), the ratio of the constitutional unit derived from terephthalic acid in 100 mol% of the constitutional units derived from dicarboxylic acids is preferably 2 mol% or more, and more preferably 20 mol% or more. In the polyamide (a), the ratio of the constitutional unit derived from terephthalic acid in 100 mol% of the constitutional units derived from dicarboxylic acids is preferably 60 mol% or less, and more preferably 50 mol% or less. For example, in the polyamide (a), the ratio of the constitutional unit derived from terephthalic acid in 100 mol% of the constitutional units derived from dicarboxylic acids is preferably 2 mol% or more and 60 mol% or less, and more preferably 20 mol% or more and 50 mol% or less.

The ratios can be measured by an NMR method.

In the polyamide (a), the total ratio of the constitutional unit derived from isophthalic acid and the constitutional unit derived from terephthalic acid in 100 mol% of the constitutional units derived from dicarboxylic acids is preferably 60 mol% or more, more preferably 70 mol% or more, still more preferably 80 mol% or more, particularly preferably 90 mol% or more, 95 mol% or more, or 98 mol% or more. The polyamide (a) may have a constitutional unit derived from a dicarboxylic acid (for example, adipic acid) other than isophthalic acid and terephthalic acid, if necessary.

The polyamide (a) preferably has a constitutional unit derived from hexamethylenediamine as a diamine component. In the polyamide (a), the ratio of the constitutional unit derived from hexamethylenediamine in 100 mol% of the constitutional units derived from diamines is preferably 60 mol% or more, more preferably 70 mol% or more, still more preferably 80 mol% or more, particularly preferably 90 mol% or more, 95 mol% or more, or 98 mol% or more. The polyamide (a) may have a constitutional unit derived from a diamine other than hexamethylenediamine, if necessary.

The polyamide (a) is preferably PA6I/6T.

The glass transition temperature of the amorphous aromatic polyamide is, for example, 90°C or more, preferably 95°C or more, and more preferably 100°C or more. The glass transition temperature of the amorphous aromatic polyamide is, for example, 180°C or less, preferably 160°C or less, and more preferably 150°C or less. The glass transition temperature of the amorphous aromatic polyamide is, for example, 90°C or more and 180°C or less, preferably 95°C or more and 160°C or less, and more preferably 100°C or more and 150°C or less.

The glass transition temperature is obtained by differential scanning calorimetry (DSC) described later.

In one embodiment, the first resin layer includes one type of polyamide resin.

When the polyamide resin contained in the first resin layer is of one type, the content of the polyamide resin in the first resin layer is preferably 70 mass% or more, more preferably 80 mass% or more, and still more preferably 90 mass% or more. When the polyamide resin contained in the first resin layer is of one type, the upper limit value of the content of the polyamide resin in the first resin layer is 100 mass%.

When the polyamide resin contained in the first resin layer is of one type, the polyamide resin is preferably an amorphous polyamide, and more preferably an amorphous aromatic polyamide. Specific examples of the amorphous polyamide and the amorphous aromatic polyamide are as described above.

In one embodiment, the polyamide resin included in the first resin layer is of two types, a first polyamide and a second polyamide.

When the polyamide resin included in the first resin layer is of two types, the first polyamide and the second polyamide, the first polyamide is an aromatic polyamide or an alicyclic polyamide.

When the polyamide resin contained in the first resin layer is of two types, the first polyamide and the second polyamide, the second polyamide is an aromatic polyamide, an alicyclic polyamide, or an aliphatic chain polyamide.

In one embodiment, the first polyamide is an aromatic polyamide and the second polyamide is an aromatic polyamide.

In one embodiment, the first polyamide is an aromatic polyamide and the second polyamide is an alicyclic polyamide.

In one embodiment, the first polyamide is an aromatic polyamide and the second polyamide is an aliphatic chain polyamide.

In one embodiment, the first polyamide is an alicyclic polyamide and the second polyamide is an aromatic polyamide.

In one embodiment, the first polyamide is an alicyclic polyamide and the second polyamide is an alicyclic polyamide.

In one embodiment, the first polyamide is an alicyclic polyamide and the second polyamide is an aliphatic linear polyamide.

Specific examples of the aromatic polyamides, the alicyclic polyamides, and the aliphatic chain polyamides are as described above.

When the polyamide resin contained in the first resin layer is of two types, the first polyamide and the second polyamide, the content of the first polyamide in the first resin layer is preferably 50 mass% or more, more preferably 60 mass% or more, and still more preferably 80 mass% or more. When the polyamide resin contained in the first resin layer is of two types, the first polyamide and the second polyamide, the content of the first polyamide in the first resin layer is preferably 95 mass% or less, more preferably 92 mass% or less, still more preferably 90 mass% or less. For example, when the polyamide resin contained in the first resin layer is of two types, the first polyamide and the second polyamide, the content of the first polyamide in the first resin layer is preferably 50 mass% or more and 95 mass% or less, more preferably 60 mass% or more and 92 mass% or less, and still more preferably 80 mass% or more and 90 mass% or less.

When the polyamide resin contained in the first resin layer is of two types, the first polyamide and the second polyamide, the content of the second polyamide in the first resin layer is preferably 5 mass% or more, more preferably 8 mass% or more, and still more preferably 10 mass% or more. When the polyamide resin contained in the first resin layer is of two types, the first polyamide and the second polyamide, the content of the second polyamide in the first resin layer is preferably 50 mass% or less, more preferably 40 mass% or less, still more preferably 20 mass% or less. For example, when the polyamide resin contained in the first resin layer is of two types, the first polyamide and the second polyamide, the content of the second polyamide in the first resin layer is preferably 5 mass% or more and 50 mass% or less, more preferably 8 mass% or more and 40 mass% or less, and still more preferably 10 mass% or more and 20 mass% or less.

In the present disclosure, the glass transition temperature of the resin constituting the first resin layer 11 is 155°C or lower, preferably 130°C or lower, and more preferably 115°C or lower. In the present disclosure, the glass transition temperature of the resin constituting the first resin layer 11 is preferably 60°C or higher, more preferably 90°C or higher, and still more preferably 100°C or higher. A barrier film produced from a polymer film including such a first resin layer 11 is excellent in, for example, gas barrier properties.

For example, the glass transition temperature of the resin constituting the first resin layer 11 is preferably 60°C or higher and 155°C or lower, more preferably 90°C or higher and 130°C or lower, and still more preferably 100°C or higher and 115°C or lower.

The glass transition temperature of the resin constituting the first resin layer 11 refers to the glass transition temperature of the resin when the resin constituting the first resin layer 11 is of one type, or refers to the glass transition temperature of a resin composition containing two or more types of resins when the resin constituting the first resin layer 11 is of two or more types. In a case where the resin constituting the first resin layer 11 does not have a glass transition temperature, it does not provide the polymer film 10 of the present disclosure.

The glass transition temperature of the resin constituting the first resin layer 11 is obtained by differential scanning calorimetry (DSC) described later.

The glass transition temperature of the resin constituting the first resin layer 11 can be adjusted by appropriately adjusting the types and ratios of the monomers used in the synthesis of the polyamide resin. In addition, when the polyamide resin contained in the first resin layer is of two or more types, the glass transition temperature of the resin constituting the first resin layer 11 can also be adjusted by mixing two or more types of polyamide resins at an appropriate ratio. For example, when the content of the amorphous polyamide in the first resin layer 11 is increased, the glass transition temperature of the resin constituting the first resin layer 11 tends to increase.

In the present disclosure, the resin constituting the first resin layer 11 does not have a cold crystallization temperature. When the resin constituting the first resin layer 11 does not have a cold crystallization temperature, contraction due to crystallization is less likely to occur in the first resin layer, and cracks are less likely to occur in the vapor deposition film 15 in contact with the first resin layer 11. As a result, a barrier film produced using the polymer film 10 has excellent gas barrier properties.

The cold crystallization temperature of the resin constituting the first resin layer 11 is the cold crystallization temperature of the resin when the resin constituting the first resin layer 11 is of one type, or is the cold crystallization temperature of a resin composition containing two or more types of resins when the resin constituting the first resin layer 11 is of two or more types.

The cold crystallization temperature of the resin constituting the first resin layer 11 is also obtained by differential scanning calorimetry (DSC) described later.

The first resin layer 11 composed of a resin having no cold crystallization temperature can be formed by appropriately adjusting the types and ratios of monomers used for synthesis of the polyamide resin. When the polyamide resin contained in the first resin layer is of two or more types, the first resin layer 11 composed of a resin having no cold crystallization temperature can also be formed by mixing two or more types of polyamide resins at an appropriate ratio. For example, when the content of the amorphous polyamide in the first resin layer 11 is increased, the resin constituting the first resin layer 11 tends not to have a cold crystallization temperature.

In the present disclosure, the resin constituting the first resin layer 11 may have a melting point or may not have a melting point, but preferably has no melting point. The polymer film 10 in which the resin constituting the first resin layer 11 does not have a melting point has, for example, excellent film-forming properties.

The melting point of the resin constituting the first resin layer 11 is the melting point of the resin when the resin constituting the first resin layer 11 is of one type, or is the melting point of a resin composition containing two or more types of resins when the resin constituting the first resin layer 11 is of two or more types.

The melting point of the resin constituting the first resin layer 11 can also be obtained by differential scanning calorimetry (DSC) described later.

In the present disclosure, when the resin constituting the first resin layer 11 has a melting point, the melting point of the resin constituting the first resin layer 11 is preferably 170°C or higher, more preferably 180°C or higher, and still more preferably 185°C or higher. In the present disclosure, when the resin constituting the first resin layer 11 has a melting point, the melting point of the resin constituting the first resin layer 11 is preferably 240°C or lower, more preferably 200°C or lower, and still more preferably 190°C or lower. A barrier film produced from a polymer film including such a first resin layer 11 is excellent in, for example, gas barrier properties.

For example, when the resin constituting the first resin layer 11 has a melting point, the melting point of the resin constituting the first resin layer 11 is preferably 170°C or more and 240°C or less, more preferably 180°C or more and 200°C or less, and still more preferably 185°C or more and 190°C or less.

By appropriately adjusting the types and ratios of the monomers used in the synthesis of the polyamide resin, it is possible to form the first resin layer 11 constituted by a resin that does not have a cold crystallization temperature, or it is possible to form the first resin layer 11 constituted by a resin having the above-mentioned melting point. When the polyamide resin contained in the first resin layer is of two or more types, the first resin layer 11 made of a resin having no cold crystallization temperature can be formed or the first resin layer 11 made of a resin having the above-mentioned melting point can be formed by mixing two or more types of polyamide resins at an appropriate ratio. For example, when the content of the amorphous polyamide in the first resin layer 11 is increased, the resin constituting the first resin layer 11 tends not to have a melting point.

Next, a detailed measurement method of differential scanning calorimetry (DSC), which is a method for obtaining the glass transition temperature, the cold crystallization temperature, and the melting point of the resin constituting the first resin layer 11, will be described.

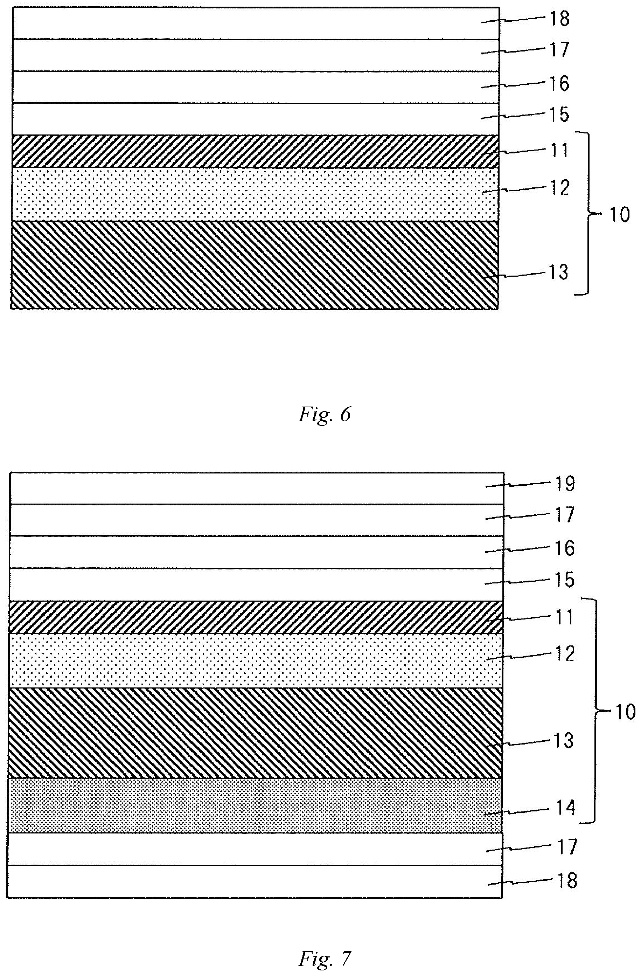

The surface of the first resin layer 11 of a base film 10 shown in Fig. 1 or Fig. 2, a barrier film shown in Fig. 3, Fig. 4, or Fig. 5, or a laminate provided by lamination and shown in Fig. 6 or Fig. 7 is scraped off with a commercially available scalpel or a single-edged blade to prepare a sample. In the case of the laminate shown in Fig. 6 or Fig. 7, a sample is prepared by peeling with a solvent or the like so as to expose the surface of the first resin layer 11, and scraping with a commercially available scalpel or single-edged blade after peeling. A sample of about 1 mg is packed in an aluminum pan, and heat flux differential scanning calorimetry (heat flux DSC) among techniques of differential scanning calorimetry (DSC) is performed using a differential scanning calorimeter (manufactured by Hitachi High-Tech Science Corporation, product name: DSC7000X) as follows.

After the sample is held at 20°C for 5 minutes, the temperature is increased from 20°C to 300°C at a temperature increase rate of 20°C/min (the first temperature increase), and the sample is held at 300°C for 5 minutes. Next, the temperature is decreased from 300°C to 20°C at a temperature decrease rate of 20°C/min (the first temperature decrease), and the sample is held at 20°C for 5 minutes. Further, the temperature is increased from 20°C to 300°C at a temperature increase rate of 20°C/min (the second temperature increase), and the sample is held at 300°C for 5 minutes. Indium is used for temperature calibration, and the flow rate of the nitrogen gas is 20 mL/min.

The melting peak temperature (Tpm) is determined from the DSC curve obtained by the first temperature increase, and is taken as the melting point of the resin constituting the first resin layer 11. However, since the melting peak at 155°C or more and less than 165°C is the melting peak of polypropylene derived from the second resin layer 12 or the third resin layer 13 scraped off together with the first resin layer 11, the melting peak temperature (Tpm) at 155°C or more and less than 165°C is not regarded as the melting peak temperature of the resin constituting the first resin layer 11. When a melting peak cannot be observed in the DSC curve obtained by the first temperature increase, it is determined that the resin constituting the first resin layer 11 does not have a melting point.

An extrapolated glass transition onset temperature (Tig) is obtained from the DSC curve obtained by the second temperature increase, and is taken as the glass transition temperature of the resin constituting the first resin layer 11. When neither a stepwise change nor a peak due to enthalpy relaxation can be observed in the DSC curve obtained by the second temperature increase, it is determined that the resin constituting the first resin layer 11 does not have a glass transition temperature.

The cold crystallization peak temperature (Tpc) is determined from the DSC curve obtained by the second temperature increase, and is taken as the cold crystallization temperature of the resin constituting the first resin layer 11. When a cold crystallization peak cannot be observed in the DSC curve obtained by the second temperature increase, it is determined that the resin constituting the first resin layer 11 does not have a cold crystallization temperature.

Other conditions are in accordance with the provisions of JIS K 7121:2012 (Testing Methods for Transition Temperatures of Plastics (JIS K 7121:1987 Main Text 001)).

The ratio of the thickness of the first resin layer 11 to the total thickness of the polymer film 10 is preferably 1% or more, and more preferably 2% or more. In this case, the gas barrier properties of the polymer film 10 can be improved by the high gas barrier properties of the first resin layer 11, in addition, the adhesion to the vapor deposition film 15 can be increased, and the gas barrier properties can be further improved. Further, the ratio of the thickness of the first resin layer 11 to the total thickness of the polymer film 10 is preferably 10% or less, and more preferably 5% or less. In this case, the film-forming properties and the processability of the polymer film 10 can be further improved, and the ratio of the constituent materials other than polypropylene in the polymer film 10 can be suppressed to improve the recyclability.

For example, the ratio of the thickness of the first resin layer 11 to the total thickness of the polymer film 10 is preferably 1% or more and 10% or less, and more preferably 2% or more and 5% or less.

In addition, the first resin layer 11 may contain a resin other than polyamide, such as polyester, an acrylic resin, or an ionomer resin, as long as processability and physical properties are not affected.

The first resin layer 11 may contain one or two or more types of additives. Examples of the additives include crosslinking agents, anti-blocking agents, slip agents, antioxidants, ultraviolet absorbents, light stabilizers, fillers, reinforcing agents, antistatic agents, pigments, dyes, and modifying resins.

Examples of the slip agents include a hydrocarbon-based slip agent, a fatty acid-based slip agent, a fatty acid amide-based slip agent, an ester-based slip agent, and metal soap. The slip agents may be in a liquid form or a solid form.

Examples of the hydrocarbon-based slip agent include liquid paraffin, natural paraffin, polyethylene wax, and microwax. Examples of the fatty acid-based slip agent include stearic acid and lauric acid. Examples of the fatty acid amide-based slip agent include stearic acid amide, palmitic acid amide, N-oleylpalmitic acid amide, behenic acid amide, erucic acid amide, arachidic acid amide, oleic acid amide, methylenebisstearamide, and ethylenebisstearamide. Examples of the ester-based slip agent include butyl stearate, hydrogenated castor oil, ethylene glycol monostearate, and stearic acid monoglyceride. Examples of the metal soap include zinc stearate and calcium stearate.

The thickness of the first resin layer 11 is preferably 0.1 µm or more, more preferably 0.2 µm or more, and still more preferably 0.3 µm or more. In this case, the gas barrier properties of the polymer film 10 can be improved by the high gas barrier properties of the first resin layer 11, and in addition, the adhesion to the vapor deposition film 15 increases, and the gas barrier properties can be further improved. The thickness of the first resin layer is preferably 5 µm or less, more preferably 4 µm or less, still more preferably 3 µm or less, yet more preferably 2 µm or less, and particularly preferably 1.5 µm or less. In this case, the ratio of the constituent materials other than polypropylene in the polymer film 10 can be suppressed to improve the recyclability.

For example, the thickness of the first resin layer 11 is preferably 0.1 µm or more and 5 µm or less, more preferably 0.1 µm or more and 4 µm or less, still more preferably 0.2 µm or more and 3 µm or less, yet more preferably 0.2 µm or more and 2 µm or less, and particularly preferably 0.3 µm or more and 1.5 µm or less.

The first resin layer 11 may be subjected to a surface treatment. Thus, the adhesion to the vapor deposition film 15 can be improved. The process of performing the surface treatment is not particularly limited and may be a physical treatment such as a corona discharge treatment, an ozone treatment, a low-temperature plasma treatment or a glow-discharge treatment using one or more selected from the group consisting of argon gas, oxygen gas and nitrogen gas, or a chemical treatment such as an oxidation treatment using a chemical agent.

### (Third resin layer)

The third resin layer 13 includes a polypropylene resin layer, and the polypropylene resin layer may be a single layer or a multilayer including a regrind layer. When the third resin layer 13 includes a polypropylene resin layer, heat resistance can be imparted to the polymer film 10.

The polypropylene contained in the polypropylene resin layer contains homopolypropylene as a main component, and may contain a polypropylene random copolymer and a polypropylene block copolymer. The polypropylene random copolymer and the polypropylene block copolymer may be contained as a layer or a mixture. The homopolypropylene is a polymer of only propylene, and the polypropylene random copolymer is a random copolymer of propylene and an olefin other than propylene (for example, ethylene, 1-butene, 1-pentene, 4-methyl-1-pentene, 1-hexene, or 1-octene). The polypropylene block copolymer is a copolymer having a polymer block composed of propylene and a polymer block composed of the above-described olefin other than propylene.

The content of the homopolypropylene in the third resin layer 13 is preferably 51 mass% or more, more preferably 60 mass% or more, and still more preferably 70 mass% or more.

In order to impart good transparency to the third resin layer 13, a random copolymer may be added in addition to the homopolypropylene. When a packaging bag is produced using a laminate in which another film is laminated on the barrier film, it is preferable to use only homopolypropylene when rigidity and heat resistance are important, and it is preferable to add a polypropylene random copolymer and/or a polypropylene block copolymer to homopolypropylene or use a polypropylene random copolymer and/or a polypropylene block copolymer when impact resistance and the like are important. Further, biomass-derived polypropylene or mechanically recycled or chemically recycled polypropylene can also be used.

It is preferable that the first resin layer 11 does not contain polypropylene, but the second resin layer 12 and the third resin layer contain polypropylene, and the content of polypropylene in the polymer film 10 is preferably 70 mass% or more, more preferably 80 mass% or more, and still more preferably 90 mass% or more. Thus, the recyclability of the polymer film can be improved.

The third resin layer 13 may contain a resin material other than polypropylene as long as the characteristics of the present disclosure are not impaired. Examples of the resin material other than polypropylene include polyolefins such as polyethylene, (meth)acrylic resins, vinyl resins, cellulose resins, polyamide resins, polyesters, ionomer resins, and the like.

The third resin layer 13 can contain an additive as long as the characteristics of the present disclosure are not impaired. Examples of the additive include crosslinking agents, antioxidants, anti-blocking agents, slip agents, ultraviolet absorbents, light stabilizers, fillers, reinforcing agents, antistatic agents, pigments, and modifying resins as compatibilizers.

The thickness of the third resin layer 13 is preferably 10 µm or more, and more preferably 15 µm or more. Thus, the strength and heat resistance of the polymer film 10 can be further improved. The thickness of the third resin layer 13 is preferably 50 µm or less, more preferably 40 µm or less, and still more preferably 30 µm or less. This makes it possible to further improve the film-forming properties, processability, and productivity of the polymer film 10.

For example, the thickness of the third resin layer 13 is preferably 10 µm or more and 50 µm or less, more preferably 15 µm or more and 40 µm or less, and still more preferably 15 µm or more and 30 µm or less.

### (Second resin layer)

The second resin layer 12 contains an acid-modified product of polypropylene. The acid-modified product of polypropylene is a resin having excellent adhesion properties. The second resin layer 12 contains the acid-modified product of polypropylene; thus, the polyamide contained in the first resin layer 11 and the polypropylene in the third resin layer can be bonded to each other, and the interlayer adhesion between the first resin layer 11 and the third resin layer 13 can be improved. In addition, since the acid-modified product of polypropylene is a polypropylene-based resin similarly to homopolypropylene which is a constituent material of the third resin layer 13, by adopting the acid-modified product of polypropylene as the resin constituting the second resin layer 12, the recyclability of the polymer film 10 can be improved.

The acid-modified product of polypropylene is obtained by graft-polymerizing an unsaturated compound having one or more carboxylic acid groups, an ester of an unsaturated carboxylic acid compound having a carboxylic acid group and an alkyl alcohol, or an unsaturated compound having one or more carboxylic anhydride groups to polypropylene. The ratio of graft polymerization is preferably 1 mol% or more and 2 mol% or less. More preferably, the ratio of graft polymerization is 1 mol% or more and 2 mol% or less, and the polymer film 10 is an oriented film.

Examples of the unsaturated group include a vinyl group, a vinylene group, and an unsaturated cyclic hydrocarbon group. The unsaturated compound having a carboxylic acid group can be used alone or in combination of two or more types thereof. Examples thereof include unsaturated carboxylic acids such as acrylic acid, methacrylic acid, maleic acid, fumaric acid, tetrahydrophthalic acid, itaconic acid, citraconic acid, crotonic acid, nadic acid, and endo-cis-bicyclo[2,2,1]hept-5-ene-2,3-dicarboxylic acid. As the unsaturated compound having one or more carboxylic anhydride groups, maleic anhydride is suitable.

In the acid-modified product of polypropylene, the polypropylene to be acid-modified is homopolypropylene, a polypropylene random copolymer or a polypropylene block copolymer, and a plurality of these may be used. In addition, such acid-modified products may be mixed. In particular, a polypropylene random copolymer is preferably used as a main component. The polypropylene random copolymer is a random copolymer of propylene and an olefin other than propylene. The polypropylene block copolymer is a copolymer having a polymer block composed of propylene and a polymer block composed of the above-described olefin other than propylene.

As the acid-modified product of polypropylene, commercially available products can be used. For example, ADMER series manufactured by Mitsui Chemicals, Inc. or Modic series manufactured by Mitsubishi Chemical Corporation can be used.

The thickness of the second resin layer 12 is preferably 0.2 µm or more, and more preferably 0.5 µm or more. Thus, the adhesion between the first resin layer 11 and the third resin layer 13 can be further improved. The thickness of the second resin layer 12 is preferably 15 µm or less, more preferably 5 µm or less, and still more preferably 2 µm or less. Thus, the processability of the polymer film 10 can be improved.

For example, the thickness of the second resin layer 12 is preferably 0.2 µm or more and 15 µm or less, more preferably 0.5 µm or more and 5 µm or less, and still more preferably 0.5 µm or more and 2 µm or less.

The ratio of the thickness of the second resin layer 12 to the total thickness of the polymer film 10 is preferably 1% or more, and more preferably 2.5% or more. Thus, the adhesion between the first resin layer 11 and the third resin layer 13 can be improved. In addition, the ratio of the thickness of the second resin layer 12 to the total thickness of the polymer film 10 is preferably 20% or less, and more preferably 10% or less. Thus, the processability can be improved, and the cost can be reduced.

For example, the ratio of the thickness of the second resin layer 12 to the total thickness of the polymer film 10 is preferably 1% or more and 20% or less, and more preferably 2.5% or more and 10% or less.

In the second resin layer 12, which contains an acid-modified product of polypropylene, a layer containing an acid-modified product of polypropylene may be provided on the first resin layer 11 side, and a layer containing, as a main component, a polypropylene random copolymer and containing no acid-modified product may be provided on the third resin layer 13 side. The layer on the first resin layer 11 side contains the acid-modified product as a main component to enhance adhesion to the first resin layer 11, and the layer containing no acid-modified product is provided on the third resin layer 13 side and bonded to the third resin layer 13. As a result, the amount of the acid-modified product to be used can be reduced and the cost can be reduced. The thickness of the second resin layer 12 can be set to 0.2 µm or more and 15 µm or less as a whole by setting the thickness of the layer containing an acid-modified product of polypropylene as a main component to 0.1 µm or more and 5 µm or less and the thickness of the layer of polypropylene containing no acid-modified product to 0.1 µm or more and 14.9 µm or less.

### (Fourth resin layer)

As shown in Fig. 2, the polymer film 10 can include a fourth resin layer 14 on a side of the third resin layer 13 opposite the second resin layer 12. The fourth resin layer 14 includes a copolymer of propylene and an olefin other than propylene. Examples of the copolymer of propylene and an olefin other than propylene include a polypropylene random copolymer. The polypropylene random copolymer is a random copolymer of propylene and an olefin other than propylene (for example, ethylene, 1-butene, 1-pentene, 4-methyl-1-pentene, 1-hexene, or 1-octene). Examples of the random copolymer include an ethylene-propylene random copolymer and an ethylene-1-butene-propylene random copolymer. The fourth resin layer 14 may include, in addition to the copolymer of propylene and an olefin other than propylene, one or more selected from the group consisting of homopolypropylene, a polypropylene block copolymer and polyethylene. Among these, it is preferable to further include polyethylene, and it is more preferable to further include high-density polyethylene. The fourth resin layer 14 contains the copolymer of propylene and an olefin other than propylene in an amount of preferably 51 mass% or more, more preferably 60 mass% or more, further preferably 70 mass% or more, and still further preferably 95 mass% or more. Thus, sufficient impact strength can be obtained. The upper limit value of the content of the copolymer of propylene and an olefin other than propylene in the fourth resin layer 14 is 100 mass%, and particularly preferably substantially 100 mass%. For example, the content of the copolymer of propylene and an olefin other than propylene in the fourth resin layer 14 is preferably 51 mass% or more and 100 mass% or less, more preferably 60 mass% or more and 100 mass% or less, still more preferably 70 mass% or more and 100 mass% or less, further more preferably 95 mass% or more and 100 mass% or less.

The thickness of the fourth resin layer 14 is preferably 0.2 µm or more, and more preferably 0.4 µm or more. Thus, the drop impact strength can be increased. In addition, the thickness of the fourth resin layer 14 is preferably 15 µm or less, more preferably 5 µm or less, and still more preferably 2 µm or less. Thus, the processability of the polymer film 10 can be improved.

For example, the thickness of the fourth resin layer 14 is preferably 0.2 µm or more and 15 µm or less, more preferably 0.4 µm or more and 5 µm or less, and still more preferably 0.4 µm or more and 2 µm or less.

The ratio of the thickness of the fourth resin layer 14 to the total thickness of the polymer film 10 is preferably 1% or more, and more preferably 2% or more. Thus, the drop impact strength can be increased. In addition, the ratio of the thickness of the fourth resin layer 14 to the total thickness of the polymer film 10 is preferably 20% or less, and more preferably 10% or less. Thus, the processability can be improved, and sufficient rigidity can be imparted to the polymer film 10.

For example, the ratio of the thickness of the fourth resin layer 14 to the total thickness of the polymer film 10 is preferably 1% or more and 20% or less, and more preferably 2% or more and 10% or less.

As shown in Fig. 6, the polymer film 10 not provided with the fourth resin layer 14 is formed into a laminate by laminating a heat sealable heat sealant film 18 containing another polypropylene on the vapor deposition film 15 side. The heat sealant film 18 of the obtained laminate is thermally fused to form a packaging bag, which is filled with contents and sealed.

A laminate having a configuration in which the polymer film 10 including the vapor deposition film 15 and not including the fourth resin layer 14 is sandwiched between other two films can also be considered. In this case, a polypropylene base film 19 containing polypropylene is laminated on the side of the vapor deposition film 15, and a heat sealant film 18 containing polypropylene is laminated on the side of the third resin layer 13 to form a laminate. The heat sealant film 18 is thermally fused to form a packaging bag, which is filled with contents and sealed. This packaging bag may be broken due to drop impact.

As shown in Fig. 7, it is also possible to laminate a polypropylene base film 19 containing polypropylene on the vapor deposition film 15 side of the barrier film having the vapor deposition film 15 on the first resin layer 11 side of the polymer film 10 provided with the fourth resin layer 14, and laminate a heat sealant film 18 containing polypropylene on the third resin layer 13 side to obtain a laminate in which the three types of films are laminated. By using this laminate as a packaging material, it is possible to prevent bag breakage due to drop impact of a packaging bag to be produced.

In the case where the third resin layer 13 contains homopolypropylene as a main component, if the crystallinity of the homopolymer is high and the homopolymer is crystallized in layers, the homopolypropylene may undergo cohesive failure between the crystals in layers due to impact. It is considered that polypropylene random copolymers have low crystallinity, the polymers are entangled, and cohesive failure due to impact is less likely to occur.

The content of polypropylene in the polymer film 10 including the fourth resin layer 14 is preferably 70 mass% or more, more preferably 80 mass% or more, and still more preferably 90 mass% or more. The content of polypropylene in the polymer film 10 not including the fourth resin layer 14 is also preferably 70 mass% or more, more preferably 80 mass% or more, and further preferably 90 mass% or more. Thus, the recyclability of the polymer film can be improved. The polypropylene may be any of homopolypropylene, polypropylene random copolymers, polypropylene block copolymers, and acid-modified products of these polypropylenes.

### (Production of polymer film 10)

The polymer film 10 is preferably a film subjected to a stretching treatment. The stretching treatment may be uniaxial stretching or biaxial stretching. That is, the polymer film 10 may be a uniaxially oriented film or a biaxially oriented film. The polymer film 10 subjected to the biaxial stretching treatment can be produced by, for example, forming at least the first resin layer 11, the second resin layer 12, and the third resin layer 13 into a sheet shape by multilayer coextrusion, and stretching the extruded sheet in the machine direction (MD direction) and the transverse direction (TD direction). In the case of the polymer film 10 further including the fourth resin layer, the first resin layer 11, the second resin layer 12, the third resin layer 13, and the fourth resin layer may be formed into a sheet shape by multilayer coextrusion, and the extruded sheet may be stretched in the machine direction and the transverse direction. Stretching in both directions is biaxial stretching, and stretching only in the machine direction or the transverse direction is uniaxial stretching. Of these, biaxial stretching is preferable. The stretch ratio is preferably 2 times or more, more preferably 3 times or more, and still more preferably 5 times or more in both the machine direction and the transverse direction. Thus, the strength and heat resistance of the polymer film 10 can be further improved. In addition, from the viewpoint of the breaking limit of the polypropylene film, the stretch ratio is preferably 15 times or less, more preferably 13 times or less, and even more preferably 10 times or less in both the machine direction and the transverse direction. The stretch ratio in the transverse direction is preferably larger than the stretch ratio in the machine direction. For example, the stretch ratio in the machine direction may be 3 times or more and 6 times or less, and the stretch ratio in the transverse direction may be 8 times or more and 13 times or less.

Biaxial stretching, which is a type of stretching treatment, may be simultaneous stretching in which stretching is performed simultaneously in the machine direction and the transverse direction, or may be sequential stretching in which stretching is performed in the machine direction and then in the transverse direction. That is, the polymer film 10 may be a simultaneously biaxially oriented film or a sequentially biaxially oriented film. The polymer film 10 is preferably a sequentially biaxially oriented film because the polymer film 10 can be produced by a simple apparatus, so that the polymer film 10 can be produced at low cost, and is also excellent in productivity.

For each resin layer, the same or different resins may be extruded from a plurality of extruders and joined together. The first resin layer 11 may have a multilayer structure in which different polyamide resins are extruded as layers by a plurality of extruders. The resin composition obtained by mixing the resins constituting the multilayered first resin layer 11 in accordance with the constituent ratio has no cold crystallization temperature and a glass transition temperature equal to or lower than the certain temperature.

The biaxial stretching method may be a method in which at least the first resin layer 11, the second resin layer 12, and the third resin layer 13 are formed into a tubular film by multilayer coextrusion, the formed tube is stretched in the MD direction while being heated, and at the same time, air is supplied into the tube to stretch the tube in the TD direction.

The third resin layer 13 may be extruded, the obtained sheet may be stretched in the machine direction, the first resin layer 11 and the second resin layer 12 may be coextruded and laminated on the uniaxially stretched third resin layer 13, and then the third resin layer 13 may be stretched in the transverse direction. As a result, the extrusion device can be simplified and the amount of work required for maintenance can be reduced. In addition, by making the widths of the first resin layer 11 and the second resin layer to be laminated on the third resin layer 13 narrower than the width of the third resin layer 13, it is possible to prevent the first resin layer 11 from being included in portions to be chucked at the time of transverse stretching and to prevent polyamide from being included in a recycled material for recycling the chucked portions, and thus recyclability of the recycled material can be enhanced.

The stretching treatment is preferably performed so that the tensile strength in the transverse direction (TD direction) of the polymer film 10 is larger than the tensile strength in the machine direction (MD direction). As a result of such a configuration, high tearability in one direction can be imparted to a packaging bag produced using the barrier film of the present disclosure. The tensile strength in the transverse direction (TD direction) of the polymer film 10 is preferably 1.05 times or more, more preferably 1.1 times or more, and still more preferably 1.2 times or more the tensile strength in the machine direction (MD direction). The tensile strength in the transverse direction (TD direction) can be, for example, 200 MPa or more and 300 MPa or less.

In the present specification, the tensile strength of the polymer film 10 is measured in accordance with JIS K 7127:1999. As a measuring device, a tensile tester STA-1150 manufactured by ORIENTEC CORPORATION can be used. As the test piece, a piece obtained by cutting the polymer film 10 into a rectangular film having a width of 15 mm and a length of 150 mm can be used. The distance between a pair of chucks holding the test piece at the start of measurement is 100 mm, and the tensile speed is 300 mm/min. In the present specification, unless otherwise specified, the environment at the time of measuring the tensile strength has a temperature of 23°C and a relative humidity of 50%.

The thickness of the polymer film 10 is preferably 10 µm or more. Thus, the strength of the polymer film 10 is improved, and the polymer film 10 is less likely to be broken during processing. Further, the thickness of the polymer film 10 is preferably 50 µm or less. As a result, when the polymer film 10 is used as a packaging material, it is possible to prevent the strength from becoming excessively higher than the required strength and to prevent waste of resources.

For example, the thickness of the polymer film 10 is preferably 10 µm or more and 50 µm or less.

In the polymer film 10, it is preferable that the thickness of the third resin layer 13 is the largest among the thicknesses of the first resin layer 11, the second resin layer 12, and the third resin layer 13, and the thicknesses of layers constituting the polymer film 10 satisfy the following formulae (1) and (2). $Thickness of first resin layer 11 \leq \left(Thickness of polymer film 10\right) / 10$ (1) $Thickness of second resin layer 12 \leq \left(Thickness of polymer film 10\right) / 5$ (2)

Since the third resin layer 13 containing homopolypropylene is the main body of the polymer film 10 and the third resin layer 13 is a layer that determines the physical properties of the polymer film 10, the thickness of the third resin layer 13 is preferably the largest.

The polyamide resin contained in the first resin layer 11 is a resin different from polypropylene, and a large amount of the polyamide resin contained in the polymer film 10 may hinder recycling; therefore, it is preferable to reduce the amount of the polyamide resin used. Therefore, the thickness of the first resin layer 11 is preferably 1/10 or less of the thickness of the polymer film 10, and more preferably 1/13.3 or less of the thickness of the polymer film 10.

The acid-modified product of polypropylene contained in the second resin layer 12 is a polypropylene-based resin and does not hinder recycling. However, since the cost is relatively high, the amount of the acid-modified product of polypropylene to be used is preferably small as long as the first resin layer 11 and the third resin layer 13 can be sufficiently bonded to each other and the stress of the expansion and contraction of the third resin layer 13 can be absorbed. Therefore, the thickness of the second resin layer 12 is preferably 1/5 or less of the thickness of the polymer film 10.

In the polymer film 10, the thickness of the first resin layer 11 constituting the polymer film 10 more preferably satisfies the following formula (3), and further preferably satisfies the following formula (4). $\left(Thickness of polymer film 10\right) / 100 \leq Thickness of first resin layer 11$ (3) $\left(Thickness of polymer film 10\right) / 50 \leq Thickness of first resin layer 11$ (4)

When the thickness of the first resin layer 11 is equal to or greater than the lower limit value, the gas barrier properties of the polymer film 10 can be improved due to the high gas barrier properties of the first resin layer 11, and in addition, the adhesion to the vapor deposition film 15 can be increased, and the gas barrier properties can be further improved.

Further, in the polymer film 10, the thickness of the first resin layer 11 constituting the polymer film 10 preferably satisfies the following (5), and more preferably satisfies the following formula (6). 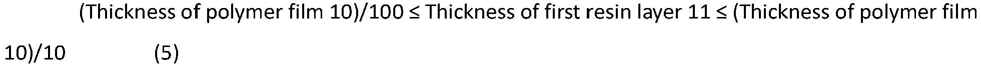 (Thickness of polymer film 10)/100 ≤ Thickness of first resin layer 11 ≤ (Thickness of polymer film 10)/10 (5) 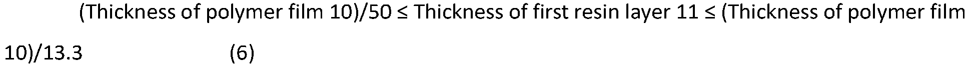 (Thickness of polymer film 10)/50 ≤ Thickness of first resin layer 11 ≤ (Thickness of polymer film 10)/13.3 (6)

In the polymer film 10, the thickness of the second resin layer 12 constituting the polymer film 10 more preferably satisfies the following formula (7). $\left(Thickness of polymer film 10\right) / 100 \leq Thickness of second resin layer 12$ (7)

When the thickness of the second resin layer 12 is equal to or greater than the lower limit value, the adhesion between the first resin layer 11 and the third resin layer 13 can be improved.

In addition, in the polymer film 10, the thickness of the second resin layer 12 constituting the polymer film 10 preferably satisfies the following (8). 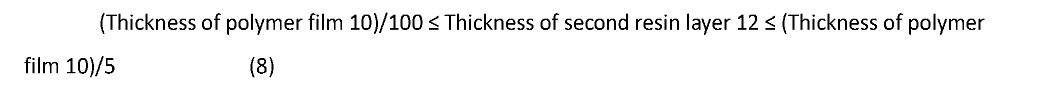 (Thickness of polymer film 10)/100 ≤ Thickness of second resin layer 12 ≤ (Thickness of polymer film 10)/5 (8)

### (Vapor deposition film 15)

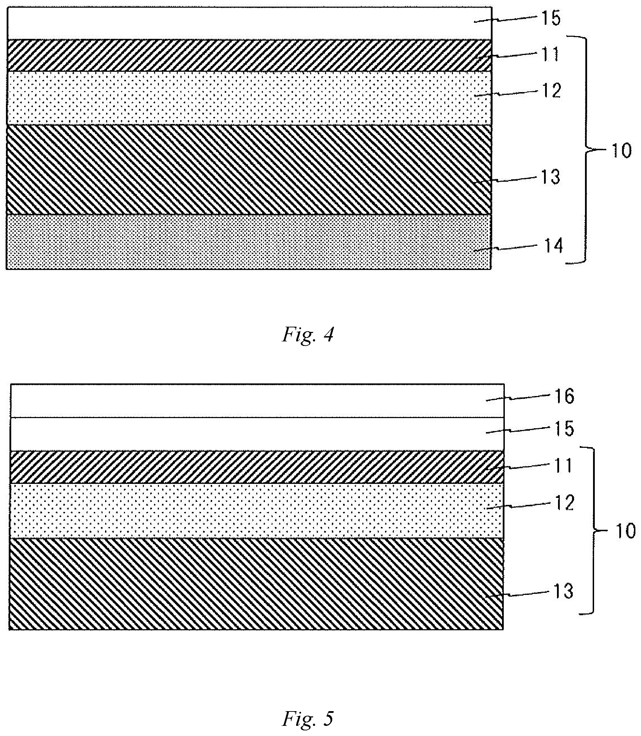

As shown in Fig. 3, the barrier film of the present disclosure includes the vapor deposition film 15 containing an inorganic oxide on the first resin layer 11 side of the polymer film 10. In addition, in the barrier film of the present disclosure, in a case where the polymer film 10 includes the fourth resin layer 14, as shown in Fig. 4, the vapor deposition film 15 containing an inorganic oxide is provided on the first resin layer 11 side. The vapor deposition film 15 may be formed on the surface of the first resin layer 11. Another layer may be provided between the first resin layer 11 and the vapor deposition film 15. By forming the vapor deposition film 15, gas barrier properties, specifically, oxygen barrier properties and water vapor barrier properties can be imparted to the barrier film. In addition, it is possible to suppress alteration of the contents and influence on the atmosphere such as the deterioration of the quality of the contents packaged by the packaging bag including the laminate prepared using the barrier film of the present disclosure due to oxidation, the deterioration of the contents due to evaporation of water vapor or moisture absorption, a decrease in the commercial value due to volatilization of the aroma component of the contents, the influence on the environment due to volatilization of the aroma component, and the like.

When a packaging bag made of a laminate including a barrier film having a vapor deposition film made of aluminum is subjected to retort treatment, the aluminum vapor deposition film is dissolved from an end surface, and a dissolved portion of the aluminum vapor deposition film is peeled off. In particular, in a shower retort where hot water is sprayed onto the article to be sterilized, this phenomenon occurs noticeably. In the dissolved portion of the aluminum vapor deposition film, the adhesion strength between the polymer film and the vapor deposition film decreases, the aluminum vapor deposition film peels off from the polymer film, and the gas barrier properties deteriorate. In order to prevent such a problem from occurring, in the barrier film of the present disclosure, the vapor deposition film 15 contains an inorganic oxide, preferably contains an inorganic oxide as a main component, and is more preferably made of an inorganic oxide.

Examples of the inorganic oxide include aluminum oxide (alumina), silicon oxide (silica), magnesium oxide, calcium oxide, zirconium oxide, titanium oxide, boron oxide, hafnium oxide, barium oxide and carbon-containing silicon oxide. Among these, silicon oxide, carbon-containing silicon oxide, and aluminum oxide are preferable.

The aluminum oxide may include aluminum hydroxide oxide AlO_{y}(OH)_{z} (where y and z represent numbers satisfying 0 ≤ y ≤ 1.5, 0 ≤ z ≤ 3, and 2y + z = 3) and aluminum hydroxide Al(OH)₃ in addition to an aluminum oxide AlOₓ (where x represents a number of 0 or more and 1.5 or less).

The inorganic oxide is more preferably a carbon-containing silicon oxide because a decrease in gas barrier properties can be suppressed even after the barrier film is bent.

The thickness of the vapor deposition film 15 is preferably 3 nm or more, more preferably 5 nm or more, and still more preferably 8 nm or more. Thus, the oxygen barrier properties and the water vapor barrier properties of the barrier film can be further improved. The thickness of the vapor deposition film 15 is preferably 150 nm or less, more preferably 60 nm or less, and still more preferably 40 nm or less. Thus, the occurrence of cracks in the vapor deposition film 15 can be prevented. In addition, when the thickness of the vapor deposition film 15 is within the above range, the recyclability is not impaired when the barrier film is used as a constituent film of a packaging material.

For example, the thickness of the vapor deposition film 15 is preferably 3 nm or more and 150 nm or less, more preferably 5 nm or more and 60 nm or less, and still more preferably 8 nm or more and 40 nm or less.

The vapor deposition film 15 can be formed by a conventionally known method. Examples of the method for forming the vapor deposition film 15 include physical vapor deposition methods (Physical Vapor Deposition methods or PVD methods) such as a vacuum vapor deposition method, a sputtering method, and an ion-plating method, and chemical vapor deposition methods (Chemical Vapor Deposition methods or CVD methods) such as a plasma chemical vapor deposition method, a thermal chemical vapor deposition method, and a photochemical vapor deposition method.

The vapor deposition film 15 may be a single layer formed by a single vapor deposition step or a multilayer formed by a plurality of vapor deposition steps. In the case of the multilayer, the layers may be formed of the same material or different materials. The respective layers may be formed by the same method or different methods.

The vapor deposition film 15 may be formed, and a layer containing an organic substance such as a barrier coat layer 16 described later may be provided on the outer surface of the vapor deposition film 15. Thus, high barrier properties can be obtained. Further, stacking of a vapor deposition film and a layer containing an organic substance may be repeated; for example, a vapor deposition film may be further provided on the surface of the layer containing an organic substance, and a layer containing an organic substance may be further provided on the outer surface of the vapor deposition film.

A plasma-assisted vacuum deposition apparatus can be used as an apparatus used in a method for forming a vapor deposition film by a PVD method. Details of this formation method are disclosed in Japanese Unexamined Patent Application Publication No. 2011-214089.

As a plasma generator used in the plasma chemical vapor deposition method, a generator of high-frequency plasma, pulse wave plasma, microwave plasma, or the like can be used. Further, an apparatus having two or more film formation chambers may be used. Details of this formation method are disclosed in Japanese Unexamined Patent Application Publication No. 2012-076292.

As an apparatus used for the method of forming the vapor deposition film 15, a continuous vapor deposition film forming apparatus including a plasma pretreatment chamber and a film formation chamber can be used. In the plasma pretreatment chamber, the first resin layer 11 included in the polymer film 10 is irradiated with plasma from the plasma supply nozzle. Next, in the film formation chamber, the vapor deposition film 15 is formed on the plasma-treated first resin layer 11. Details of this formation method are disclosed in International Publication No. 2019/087960.

The surface of the vapor deposition film 15 is preferably subjected to plasma treatment. This can improve the adhesion to the barrier coat layer 16 described later and provided on the surface of the vapor deposition film 15.

In the barrier film of the present disclosure, when the vapor deposition film 15 is a carbon-containing silicon oxide vapor deposition film, a decrease in gas barrier properties can be suppressed even after the barrier film is bent. The carbon-containing silicon oxide vapor deposition film can be formed by a CVD method.

The carbon-containing silicon oxide vapor deposition film contains silicon, oxygen, and carbon. In the carbon-containing silicon oxide vapor deposition film, the ratio of carbon is preferably 3% or more, more preferably 5% or more, and still more preferably 10% or more with respect to 100% of the total of the three elements of silicon, oxygen, and carbon. In the carbon-containing silicon oxide vapor deposition film, the ratio of carbon is preferably 50% or less, more preferably 40% or less, and still more preferably 35% or less with respect to 100% of the total of the three elements of silicon, oxygen, and carbon. For example, in the carbon-containing silicon oxide vapor deposition film, the ratio of carbon is preferably 3% or more and 50% or less, more preferably 5% or more and 40% or less, and still more preferably 10% or more and 35% or less with respect to 100% of the total of the three elements of silicon, oxygen, and carbon. In the carbon-containing silicon oxide vapor deposition film, when the ratio of carbon C is in the above range, a decrease in gas barrier properties can be suppressed even after the barrier film is bent.

It is preferable that the ratio of carbon is 3% or more and 50% or less, the ratio of oxygen is 30% or more and 65% or less, and the ratio of silicon is 25% or more and 40% or less with respect to 100% of the total of the three elements of carbon, oxygen, and silicon. When the ratio of carbon is 3% or more, a decrease in gas barrier properties can be further suppressed even after the barrier film is bent. When the ratio of carbon is 50% or less, the tint of the appearance can be suppressed.

### (Measurement of ratios of elements of carbon-containing silicon oxide vapor deposition film)

The ratios of carbon, silicon, and oxygen in the carbon-containing silicon oxide vapor deposition film can be measured by X-ray photoelectron spectroscopy (XPS) described below.

A narrow spectrum of each element at the surface of the carbon-containing silicon oxide vapor deposition film is measured using an X-ray photoelectron spectrometer (XPS). Thereafter, the surface after measurement is etched under the conditions described later to expose a new measurement surface. A narrow spectrum of each element is measured at the exposed measurement surface under the same conditions.

For each of the narrow spectra of C1s, O1s, and Si2p, the background is subtracted by the Shirley method using analysis software to obtain the integrated intensity (area) of the peak of each element. The ratio of each element (element%) is calculated using the obtained integrated intensity (area). To reduce the effect of surface contamination, the ratio of each element after a single 30-second etching is used.

### <X-ray photoelectron spectrum measurement conditions>

Device: ESCA3400 manufactured by SHIMADZU CORPORATION
X-ray source: MgKα
Emission current: 20 mA
Acceleration voltage: 10 kV
Resolution: Low
Measurement region: about 6 mmϕ

### <Etching conditions>

Ion species: Ar⁺
Pressure of Ar gas introduction: 2.0×10⁻² Pa
Emission current: 30 mA
Acceleration voltage: 0.3 kV
Etching time: 30 seconds × 1 time

### (Barrier coat layer 16)

In one embodiment of the barrier film of the present disclosure, as shown in Fig. 5, the barrier coat layer 16 may be provided on the vapor deposition film 15. By forming the barrier coat layer 16 on the surface of the vapor deposition film 15, the oxygen barrier properties and the water vapor barrier properties of the barrier film are further improved.

In one embodiment of the barrier film of the present disclosure, although not shown, when the polymer film 10 includes the fourth resin layer 14, the barrier coat layer 16 may be provided on the vapor deposition film 15. By forming the barrier coat layer 16 on the surface of the vapor deposition film 15, the oxygen barrier properties and the water vapor barrier properties of the barrier film are further improved.

The barrier coat layer 16 contains a gas barrier resin such as an ethylene-vinyl alcohol copolymer (EVOH), polyvinyl alcohol (PVA), polyester, polyurethane, or a (meth)acrylic resin. Among these, polyvinyl alcohol is preferable from the viewpoint of improving oxygen barrier properties and water vapor barrier properties. By incorporating polyvinyl alcohol into the barrier coat layer 16, the occurrence of cracks in the vapor deposition film 15 can be effectively prevented.

The content of the gas barrier resin in the barrier coat layer 16 is preferably 50 mass% or more, and more preferably 75 mass% or more. Thus, the oxygen barrier properties and the water vapor barrier properties can be further improved. The content of the gas barrier resin in the barrier coat layer 16 is 100 mass% or less, preferably 95 mass% or less, more preferably 90 mass% or less.

For example, the content of the gas barrier resin in the barrier coat layer 16 is preferably 50 mass% or more and 100 mass% or less, more preferably 50 mass% or more and 95 mass% or less, and still more preferably 75 mass% or more and 90 mass% or less.

The thickness of the barrier coat layer 16 is preferably 0.01 µm or more, more preferably 0.1 µm or more, and still more preferably 0.2 µm or more. Thus, the oxygen barrier properties and the water vapor barrier properties of the barrier film can be further improved. The thickness of the barrier coat layer 16 is preferably 10 µm or less, more preferably 5 µm or less, and still more preferably 1 µm or less. Thus, the processability of the barrier film can be improved. In addition, when the thickness of the barrier coat layer 16 is within the above range, the recyclability is not impaired even when the barrier coat layer 16 is made of a material different from polypropylene.

For example, the thickness of the barrier coat layer 16 is preferably 0.01 µm or more and 10 µm or less, more preferably 0.1 µm or more and 5 µm or less, and still more preferably 0.2 µm or more and 1 µm or less.

The barrier coat layer 16 can be formed by dissolving or dispersing the above-mentioned gas barrier resin in water or an appropriate solvent, followed by coating and drying.

The barrier coat layer 16 is preferably a gas barrier coating film containing at least one resin composition such as a hydrolysate of a metal alkoxide or a hydrolysis-condensation product of a metal alkoxide obtained by polycondensation of a mixture of a metal alkoxide and a water-soluble polymer by a sol-gel method in the presence of a sol-gel catalyst, water, an organic solvent, and the like. The gas barrier coating film is a gas barrier coating film of a mixture of a metal alkoxide and a water-soluble polymer, or a gas barrier coating film of a mixture of a metal alkoxide, a water-soluble polymer and a silane coupling agent. By providing such a barrier coat layer 16 on the vapor deposition film 15, the occurrence of cracks in the vapor deposition film 15 can be effectively prevented.

The metal alkoxide is represented by the following general formula.

R¹ₙM(OR²)ₘ

In the formula, R¹ and R² each represent an organic group having 1 or more and 8 or less carbon atoms, M represents a metal atom, n represents an integer of 0 or more, m represents an integer of 1 or more, and n + m represents the valence of M.

As the metal atom M, for example, silicon, zirconium, titanium, aluminum, or the like can be used. Examples of the organic groups represented by R¹ and R² include alkyl groups such as a methyl group, an ethyl group, an n-propyl group, an i-propyl group, an n-butyl group, and an i-butyl group.

Examples of the metal alkoxide satisfying the above general formula include tetramethoxysilane (Si(OCH₃)₄), tetraethoxysilane (Si(OC₂H₅)₄), tetrapropoxysilane (Si(OC₃H₇)₄), and tetrabutoxysilane (Si(OC₄H₉)₄).

A silane coupling agent may be used together with the metal alkoxide. As the silane coupling agent, known organoalkoxysilanes containing an organic reactive group can be used, and examples thereof include vinyltrimethoxysilane, γ-chloropropylmethyldimethoxysilane, γ-chloropropyltrimethoxysilane, 3-glycidoxypropylmethyldimethoxysilane, 3-glycidoxypropyltrimethoxysilane, 3-glycidoxypropylmethyldiethoxysilane, 3-glycidoxypropylmethyltriethoxysilane, γ-methacryloxypropyltrimethoxysilane, γ-methacryloxypropylmethyldimethoxysilane, 1,3,5-tris(3-methoxysilylpropyl)isocyanurate and the like.

Two or more types of silane coupling agents may be used, and a silane coupling agent is preferably used within a range of 1 part by mass or more and 20 parts by mass or less with respect to 100 parts by mass of the total amount of the metal alkoxide.

As the water-soluble polymer, polyvinyl alcohol and an ethylene-vinyl alcohol copolymer are preferable, and from the viewpoint of oxygen barrier properties, water vapor barrier properties, water resistance and weather resistance, it is preferable to use these in combination.

The degree of polymerization of the polyvinyl alcohol is preferably 300 or more. Thus, a decrease in gas barrier properties due to bending can be suppressed. The degree of polymerization of the polyvinyl alcohol is preferably 3000 or less. Thus, difficulty in processing can be suppressed.

For example, the degree of polymerization of the polyvinyl alcohol is preferably 300 or more and 3000 or less.

The saponification degree of the polyvinyl alcohol is preferably 90 mol% or more, more preferably 95 mol% or more, and still more preferably 99 mol% or more.

The degree of polymerization of the ethylene-vinyl alcohol copolymer is preferably 300 or more. Thus, a decrease in gas barrier properties due to bending can be suppressed. The degree of polymerization of the ethylene-vinyl alcohol copolymer is preferably 3000 or less. Thus, difficulty in processing can be suppressed.

For example, the degree of polymerization of the ethylene-vinyl alcohol copolymer is preferably 300 or more and 3000 or less.

The saponification degree of the ethylene-vinyl alcohol copolymer is preferably 90 mol% or more, more preferably 95 mol% or more, and still more preferably 99 mol% or more.

The content of the ethylene unit in the ethylene-vinyl alcohol copolymer is preferably 10 mol% or more, more preferably 15 mol% or more, still more preferably 20 mol% or more, and particularly preferably 25 mol% or more. The content of the ethylene unit in the ethylene-vinyl alcohol copolymer is preferably 65 mol% or less, more preferably 55 mol% or less, and still more preferably 50 mol% or less. For example, the content of the ethylene unit in the ethylene-vinyl alcohol copolymer is preferably 10 mol% or more and 65 mol% or less, more preferably 15 mol% or more and 55 mol% or less, further preferably 20 mol% or more and 50 mol% or less, and still further preferably 25 mol% or more and 50 mol% or less. Ethylene-vinyl alcohol copolymers having different ethylene contents may be mixed.

The thickness of the gas barrier coating film is preferably 0.01 µm or more, and more preferably 0.1 µm or more. Thus, the oxygen barrier properties and the water vapor barrier properties of the barrier film can be improved, and the occurrence of cracks in the vapor deposition film can be prevented. The thickness of the gas barrier coating film is preferably 1 µm or less, and more preferably 0.5 µm or less. This makes it possible to suppress the occurrence of cracks in the gas barrier coating film itself while maintaining the recyclability.

For example, the thickness of the gas barrier coating film is preferably 0.01 µm or more and 1 µm or less, and more preferably 0.1 µm or more and 0.5 µm or less.

The gas barrier coating film can be formed by applying a composition containing the above-mentioned material by a conventionally known means such as roll coating using a gravure roll coater or the like, spray coating, spin coating, dipping, brushing, bar coating, or an applicator, and polycondensing the composition by a sol-gel method. As the sol-gel method catalyst, an acid or an amine-based compound is suitable.

The composition may contain an organic solvent. As the organic solvent, for example, methyl alcohol, ethyl alcohol, n-propyl alcohol, isopropyl alcohol, n-butanol, or the like can be used.

A method for forming the gas barrier coating film will be described below. A metal alkoxide, a water-soluble polymer, a sol-gel method catalyst, water, an organic solvent, and if necessary, a silane coupling agent and the like are mixed to prepare a composition. The polycondensation reaction gradually proceeds in the composition. Next, the composition is applied onto the vapor deposition film 15 by the above-mentioned conventionally known method and dried. By the drying, the polycondensation reaction of the metal alkoxide, the water-soluble polymer, and the silane coupling agent in the case where the composition contains the silane coupling agent proceeds, and a layer of the composite polymer is formed. The heating temperature during drying is preferably 20°C or higher, more preferably 50°C or higher, and even more preferably 80°C or higher, and is preferably 250°C or lower, more preferably 200°C or lower, and even more preferably 150°C or lower. For example, the heating temperature during drying is preferably 20°C or higher and 250°C or lower, more preferably 50°C or higher and 200°C or lower, and still more preferably 80°C or higher and 150°C or lower. The drying time is preferably 1 second or more and 10 minutes or less.

A printed layer may be formed on the surface of the barrier coat layer 16.

### (Laminate)

In the barrier film of the present disclosure, the barrier coat layer 16 is provided on the surface of the vapor deposition film 15, and the barrier film is laminated with another film to form a laminate. As shown in Fig. 5, the barrier coat layer 16 is provided on the surface of the vapor deposition film 15 of the barrier film in which the vapor deposition film 15 is provided on the first resin layer side of the polymer film 10 having the first resin layer 11, the second resin layer 12, and the third resin layer 13. The surface of the vapor deposition film 15 may be laminated with another film without being provided with the barrier coat layer 16.

In the barrier film of the present disclosure, the barrier coat layer 16 is provided on the surface of the vapor deposition film 15, and the barrier film is laminated with another film to form a laminate. Although not shown, the barrier coat layer 16 is provided on the surface of the vapor deposition film 15 of the barrier film in which the vapor deposition film 15 is provided on the first resin layer 11 side of the polymer film 10 having the first resin layer 11, the second resin layer 12, the third resin layer 13, and the fourth resin layer 14. The surface of the vapor deposition film 15 may be laminated with another film without being provided with the barrier coat layer 16.

As shown in Fig. 6, the heat sealable heat sealant film 18 containing polypropylene is laminated on the barrier coat layer 16 side of the obtained barrier film provided with the barrier coat layer 16, via an adhesive layer 17 to form a laminate. The layer structure is polymer film 10/vapor deposition film 15/barrier coat layer 16/adhesive layer 17/heat sealant film 18. A printed layer may be provided on the barrier coat layer 16 side. Further, the heat sealant film 18 may be directly laminated on the barrier coat layer 16 side. In this case, the heat sealant film 18 is laminated without the adhesive layer 17 interposed.

When the barrier coat layer 16 is not provided, the heat sealable heat sealant film 18 containing polypropylene is laminated on the vapor deposition film side of the barrier film via the adhesive layer 17 to form a laminate. The layer structure is polymer film 10/vapor deposition film 15/adhesive layer 17/heat sealant film 18. Alternatively, the heat sealant film 18 may be directly laminated on the vapor deposition film 15 side. In this case, the heat sealant film 18 is laminated without the adhesive layer 17 interposed.

A polypropylene base film 19 containing polypropylene may be laminated on the vapor deposition film 15 side of the barrier film via an adhesive layer 17, and the heat sealable heat sealant film 18 containing polypropylene may be laminated on the polypropylene base film 19 via an adhesive layer 17. The layer structure of the laminate is polymer film 10/vapor deposition film 15/adhesive layer 17/polypropylene base film 19/adhesive layer 17/heat sealant film 18. When the barrier coat layer 16 is provided on the vapor deposition film 15 side, provided is polymer film 10/vapor deposition film 15/barrier coat layer 16/adhesive layer 17/polypropylene base film 19/adhesive layer 17/heat sealant film 18. A printed layer may be provided on the surface of the barrier coat layer on the vapor deposition film 15 side. The polypropylene base film 19 may be a biaxially oriented polypropylene film. Alternatively, the heat sealant film 18 may be directly laminated on the polypropylene base film 19. In this case, the heat sealant film 18 is laminated without the adhesive layer 17 interposed.

The barrier coat layer 16 is provided on the surface of the vapor deposition film 15 of the barrier film having the fourth resin layer 14 in the polymer film 10 shown in Fig. 2, and as shown in Fig. 7, the polypropylene base film 19 containing polypropylene is laminated on the barrier coat layer 16 side via an adhesive layer 17, and the heat sealant film 18 is laminated on the fourth resin layer 14 side via an adhesive layer 17 to form a laminate. The layer structure is polypropylene base film 19/adhesive layer 17/barrier coat layer 16/vapor deposition film 15/polymer film 10 including fourth resin layer 14/adhesive layer 17/heat sealant film 18. When the barrier coat layer 16 is not provided, the polypropylene base film 19 containing polypropylene is laminated on the vapor deposition film 15 side via the adhesive layer 17. The layer structure of the laminate is polypropylene base film 19/adhesive layer 17/vapor deposition film 15/polymer film 10 including fourth resin layer 14/adhesive layer 17/heat sealant film 18. In each case, the laminate includes the polypropylene base film 19 on a side of the barrier film opposite the heat sealant film 18. The polypropylene base film 19 may be a biaxially oriented polypropylene film. A printed layer may be provided on the polypropylene base film 19. Alternatively, the heat sealant film 18 may be directly laminated on the fourth resin layer 14. In this case, the heat sealant film 18 is laminated without the adhesive layer 17 interposed.

The heat sealant film 18 contains a polypropylene having a melting point of 120°C or higher as a main component. Thus, the heat resistance of the packaging material can be improved. The polypropylene is not particularly limited as long as it has a melting point of 120°C or higher. In the present specification, the "polyolefin having a melting point of 120°C or higher" means a polypropylene having a melting peak temperature (Tpm) of 120°C or higher in the above-described differential scanning calorimetry (DSC).

The heat sealant film 18 preferably includes polyethylene as the sealant material. By containing polyethylene together with polypropylene, the heat sealant film 18 can form a sea-island structure. The "sea-island structure" means a structure in which polyethylene is discontinuously dispersed in a region in which polypropylene is continuous.

When the heat sealant film 18 contains a sealant material other than polypropylene, the heat sealant film 18 is not limited to one having a sea-island structure, and may be one having a miscible blend of the two materials.

The heat sealant film 18 preferably includes a sealant material having a melting point of 150°C or higher.

A general packaging bag for heat sterilization is filled with contents and then subjected to retort treatment or boiling treatment, which may cause deterioration in gas barrier properties and heat-sealing properties. In the laminate of the present disclosure, since the heat sealant film 18 contains a polypropylene having a melting point of 150°C or higher, even when a packaging bag produced from the laminate is subjected to a heat treatment such as retort treatment or boiling treatment, a decrease in the gas barrier properties and heat-sealing properties of the packaging bag can be effectively suppressed.

The retort treatment is a treatment in which contents are filled in a packaging bag for heat sterilization and sealed, and then the packaging bag for heat sterilization is heated in a pressurized state using steam or heated hot water. The retort treatment is classified into semi-retort treatment and high-retort treatment depending on the heating temperature. In the semi-retort treatment, for example, after the central portion of the contents reaches 121°C, the contents are held for at least 3 minutes or more. In the high-retort treatment, for example, after the central portion of the contents reaches 135°C, the contents are held for at least 3 minutes or more.

The boiling treatment is a treatment in which contents are filled in a packaging bag for heat sterilization and sealed, and then the packaging bag for heat sterilization is heated using steam or heated hot water without pressurization. In the boiling treatment, for example, after the central portion of the contents reaches 90°C, the contents are held for at least 3 minutes.

The polypropylene used in the heat sealant film 18 may be any of a homopolymer, a random copolymer and a block copolymer. Among these, a block copolymer is preferable from the viewpoint of retort treatment suitability and boiling treatment suitability. By using the block copolymer, it is possible to improve the impact resistance of the packaging bag produced using the barrier film of the present disclosure. As the block copolymer, for example, a propylene-ethylene block copolymer or the like can be used.

The adhesive used for the adhesive layer 17 may be a one-component curable adhesive, a two-component curable adhesive, or a non-curable adhesive. The adhesive may be a solvent-free adhesive or a solvent-based adhesive, but from the viewpoint of environmental load, it is preferable to use a solvent-free adhesive. Examples of the solvent-free adhesive include a polyether-based adhesive, a polyester-based adhesive, a silicone-based adhesive, an epoxy-based adhesive, and a urethane-based adhesive; among these, a two-component curable urethane-based adhesive is preferably used. The adhesive may be a combination of a modified polyolefin and a curing agent. By using an adhesive containing a modified polyolefin as a main component, it is possible to reduce hindrance to recyclability caused by the adhesive.

The thickness of the adhesive layer 17 is, from the viewpoint of recyclability, preferably 10 µm or less, more preferably 5 µm or less, and still more preferably 3 µm or less. The thickness of the adhesive layer 17 is, from the viewpoint of adhesion, preferably 0.1 µm or more, more preferably 0.5 µm or more, and still more preferably 1.0 µm or more.

For example, the thickness of the adhesive layer 17 is preferably 0.1 µm or more and 10 µm or less, more preferably 0.5 µm or more and 5 µm or less, and still more preferably 1.0 µm or more and 3 µm or less.

### (Packaging bag)

The heat sealant film 18 side of the laminate is used as an inner surface, and necessary portions of the heat sealant film 18 are thermally fused to each other, whereby a packaging bag can be produced. The form of the packaging bag may be any form such as a three side sealed type, a four side sealed type, a stand type, a gusset type, a pillow type, or a type with an extraction port.

Food, a seasoning, a beverage, a supplement, a pharmaceutical, an enteral formula, pet food, or the like is filled as contents in the produced packaging bag, and the packaging bag is sealed. The sealed packaging bag is subjected to boiling treatment or retort treatment. There are also packaging bags in which the contents are heated, filled, and sealed. For example, the inner surfaces of the packaging bags are sterilized by filling the contents heated to 80°C or higher.

### EXAMPLES

Hereinafter, the present disclosure will be described more specifically by way of Examples, but the present disclosure is not limited to the following Examples.

The polyamide resins used in the following Examples and Comparative Examples are as follows.
·Polyamide A
   Amorphous aromatic polyamide, trade name: Grivory (registered trademark) G21, manufactured by EMS-CHEMIE HOLDING AG
   Polyhexamethylene isophthalamide/polyhexamethylene terephthalamide copolymer (PA6I/6T)
·Polyamide B
   Amorphous alicyclic polyamide, trade name: Grilamid (registered trademark) TR 90, manufactured by EMS-CHEMIE HOLDING AG
   Copolymer of 4,4'-methylenebis(2-methylcyclohexylamine) and dodecanedioic acid (PA MACM12)
·Polyamide C
   Mixture of amorphous alicyclic polyamide and crystalline aliphatic chain polyamide, trade name: Grilamid (registered trademark) TR90LX, manufactured by EMS-CHEMIE HOLDING AG
   Mixture of copolymer of 4,4'-methylenebis(2-methylcyclohexylamine) and dodecanedioic acid (PA MACM12) and polylauryllactam (PA12).
·Polyamide D
   Amorphous aromatic polyamide, trade name: Trogamid (registered trademark) T5000, manufactured by Polyplastics-Evonik
   Copolymer of 2,2,4-trimethylhexamethylenediamine and terephtalic acid (PA NDT/INDT)
·Polyamide E
   Crystalline aromatic polyamide, trade name: S7007, manufactured by Mitsubishi Gas Chemical Company, Inc.
   Polymetaxylyleneadipamide/polymetaxylyleneisophthalamide copolymer (PAMXD6I)
·Polyamide F
   Crystalline aliphatic chain polyamide, trade name: UBE NYLON 5033B, manufactured by UBE Corporation
   Copolymer of 6-aminocaproic acid, hexamethylenediamine and adipic acid (PA6/66)
·Polyamide G
   Amorphous aromatic polyamide, trade name: Grilamid (registered trademark) TR 30 LS, manufactured by EMS-CHEMIE HOLDING AG
   Copolymer including at least hexamethylenediamine and isophthalic acid as constitutional units (PA6I/X)

### [Example 1]

Polyamide A was used as the resin (first resin) constituting the first resin layer.

The acid-modified product of a polypropylene random copolymer (MFR: 5.0) was used as the resin (second resin) constituting the second resin layer.

Homopolypropylene (MFR: 3.0) was used as the resin (third resin) constituting the third resin layer.

As the resin (fourth resin) constituting the fourth resin layer, an ethylene-1-butene-propylene random copolymer (MFR: 5.3) was used.

The first resin, the second resin, the third resin, and the fourth resin were coextruded and then stretched 5 times in the machine direction (MD direction) and 10 times in the transverse direction (TD direction) by a sequential biaxial stretching apparatus to produce a polymer film of Example 1 including the first resin layer (0.7 µm), the second resin layer (1.3 µm), the third resin layer (17.0 µm), and the fourth resin layer (1.0 µm).

The thickness of the polymer film of Example 1 was 20 µm.

The content of polypropylene in the entire polymer film of Example 1 was 95 mass%.

### [Example 2]

A polymer film of Example 2 was produced in the same manner as in Example 1 except that a mixture of 30 mass% of polyamide B and 70 mass% of polyamide C was used as the first resin.

The constituent components of the first resin used in Example 2 were identified by ¹H-NMR spectrum measurement; as a result, the PA MACM12 content was 78.1 mass%, and the PA12 content was 21.9 mass%.

### [Example 3]

A polymer film of Example 3 was produced in the same manner as in Example 1, except that a mixture of 50 mass% of polyamide B and 50 mass% of polyamide C was used as the first resin.

The constituent components of the first resin used in Example 3 were identified by ¹H-NMR spectrum measurement; as a result, the PA MACM12 content was 84.3 mass%, and the PA12 content was 15.7 mass%.

### [Example 4]

A polymer film of Example 4 was produced in the same manner as in Example 1 except that a mixture of 70 mass% of polyamide B and 30 mass% of polyamide C was used as the first resin.

The constituent components of the first resin used in Example 4 were identified by ¹H-NMR spectrum measurement; as a result, the PA MACM12 content was 90.6 mass%, and the PA12 content was 9.4 mass%.

### [Example 5]

A polymer film of Example 5 was produced in the same manner as in Example 1, except that a mixture of 80 mass% of polyamide A and 20 mass% of polyamide D was used as the first resin.

### [Example 6]

A polymer film of Example 6 was produced in the same manner as in Example 1, except that a mixture of 60 mass% of polyamide A and 40 mass% of polyamide E was used as the first resin.

### [Example 7]

A polymer film of Example 7 was produced in the same manner as in Example 1, except that a mixture of 60 mass% of polyamide A and 40 mass% of polyamide F was used as the first resin.

### [Example 8]

A polymer film of Example 8 was produced in the same manner as in Example 1, except that a mixture of 50 mass% of polyamide A and 50 mass% of polyamide F was used as the first resin.

### [Example 9]

A polymer film of Example 9 was produced in the same manner as in Example 1 except that a mixture of 70 mass% of polyamide A and 30 mass% of polyamide F was used as the first resin.

### [Example 10]

A polymer film of Example 10 was produced in the same manner as in Example 1, except that a mixture of 50 mass% of polyamide A and 50 mass% of polyamide E was used as the first resin.

### [Example 11]

A polymer film of Example 11 was produced in the same manner as in Example 1, except that the thickness of the first resin layer was changed to 0.4 µm.

The polymer film of Example 11 had a thickness of 19.7 µm.

The content of polypropylene in the entire polymer film of Example 11 was 97 mass%.

### [Example 12]

A polymer film of Example 12 was produced in the same manner as in Example 1, except that the thickness of the first resin layer was changed to 1.5 µm.

The polymer film of Example 12 had a thickness of 20.8 µm.

The content of polypropylene in the entire polymer film of Example 12 was 91 mass%.

### [Comparative Example 1]

A polymer film of Comparative Example 1 was produced in the same manner as in Example 1 except that a mixture of 20 mass% of polyamide A and 80 mass% of polyamide E was used as the first resin.

### [Comparative Example 2]

A polymer film of Comparative Example 2 was produced in the same manner as in Example 1 except that polyamide E was used as the first resin.

### [Comparative Example 3]

A polymer film of Comparative Example 3 was produced in the same manner as in Example 1 except that polyamide F was used as the first resin.

### [Comparative Example 4]

A polymer film of Comparative Example 4 was produced in the same manner as in Example 1 except that polyamide G was used as the first resin.

### [Differential scanning calorimetry (DSC)]

Each of the polymer films of Examples 1 to 12 and Comparative Examples 1 to 4 was cut to the size of 210 mm × 297 mm, and then the surface of the first resin layer was scraped off with a trimming knife (single-edged trimming razor, product number: 121-2) to prepare a sample. 1.00 mg or more and 1.25 mg or less of the sample was packed in an aluminum pan and subjected to heat flux differential scanning calorimetry (heat flux DSC) among techniques of differential scanning calorimetry (DSC) as described below.

Using a differential scanning calorimeter (manufactured by Hitachi High-Tech Science Corporation, product name: DSC7000X), the sample was held at 20°C for 5 minutes, then heated from 20°C to 300°C at a temperature increase rate of 20°C/min (the first temperature increase), and held at 300°C for 5 minutes. Next, the temperature was decreased from 300°C to 20°C at a temperature decrease rate of 20°C/min (the first temperature decrease), and the sample was held at 20°C for 5 minutes. Further, the temperature was increased from 20°C to 300°C at a temperature increase rate of 20°C/min (the second temperature increase), and the sample was held at 300°C for 5 minutes. Indium was used for temperature calibration, and the flow rate of nitrogen gas was set to 20 mL/min.

The melting peak temperature (Tpm) was determined from the DSC curve obtained by the first temperature increase, and was defined as the melting point of the resin constituting the first resin layer. However, the melting peak temperature (Tpm) of 155°C or more and less than 165°C was not regarded as the melting peak temperature of the resin constituting the first resin layer. For samples in which a melting peak could not be observed in the DSC curve obtained by the first temperature increase, it was determined that the resin constituting the first resin layer did not have a melting point.

An extrapolated glass transition onset temperature (Tig) was obtained from the DSC curve obtained by the second temperature increase, and was defined as the glass transition temperature of the resin constituting the first resin layer. It was determined that the resin constituting the first resin layer did not have a glass transition temperature for a sample for which neither a stepwise change nor a peak due to enthalpy relaxation could be observed in the DSC curve obtained by the second temperature increase.

The cold crystallization peak temperature (Tpc) was determined from the DSC curve obtained by the second temperature increase, and was defined as the cold crystallization temperature of the resin constituting the first resin layer. For samples in which a cold crystallization peak could not be observed in the DSC curve obtained by the second temperature increase, it was determined that the resin constituting the first resin layer did not have a cold crystallization temperature.

Other conditions were in accordance with the provisions of JIS K 7121:2012 (Testing Methods for Transition Temperatures of Plastics (JIS K 7121:1987 Main Text 001)).

The results are shown in Table 1. Incidentally, "-" in Table 1 means that the melting peak temperature, the cold crystallization peak temperature or the extrapolated glass transition onset temperature could not be observed from the DSC curve.

### [Film-forming property evaluation]

For each of the polymer films of Examples 1 to 12 and Comparative Examples 1 to 4, the state immediately after the production was evaluated based on the following evaluation criteria. The results are shown in Table 1.
A: The polymer film was not curled, and the film-forming properties were excellent.
B: Although the polymer film was curled toward the first resin layer side, it was not significantly curled and had practically acceptable film-forming properties.
C: The polymer film was significantly curled toward the first resin layer side, and the film-forming properties were practically unacceptable.
D: The first resin layer was broken, and the film-forming properties were poor.

### [Heat resistance evaluation]

Each of the polymer films of Examples 1 to 12 and Comparative Examples 1 to 3 in which the first resin layer was not broken was cut into the size of 100 mm × 100 mm. Next, the polymer film was placed on a flat metal plate with the fourth resin layer facing downward. The polymer film was photographed from a position 50 cm vertically above the center of the polymer film. The area of contact between the polymer film and the flat metal plate was measured using the taken photograph.

The polymer film was subjected to heat treatment at 120°C for 20 minutes. For the polymer film after the heat treatment, the area of contact between the polymer film and the flat metal plate was measured in the same manner as before the heat treatment.

The contact area ratio of the polymer film after the heat treatment was calculated by dividing the contact area after the heat treatment by the contact area before the heat treatment. As the contact area ratio after the heat treatment is larger, the polymer film is less likely to be curled by the heat treatment and is more excellent in heat resistance. The results are shown in Table 1.

### [Examples 1A to 12A and Comparative Example 1A]

On the surface of the first resin layer of each of the polymer films of Examples 1 to 12 and Comparative Example 1, which had relatively good film-forming properties, an aluminum oxide (alumina) vapor deposition film was formed by the following procedure.

The polymer film was introduced into an unwinding section in a depressurizable chamber having the unwinding section, a plasma treatment section, a film forming section, a winding section, and the like, and the pressure in the chamber was reduced. The surface of the first resin layer of the polymer film was subjected to a plasma pretreatment using a mixed gas of argon and oxygen at a volume ratio of 1:1 while applying tension to the polymer film in a Roll-to-Roll manner using a plasma treatment apparatus; in the film forming section to which the polymer film was continuously transported, an aluminum oxide vapor deposition film having a thickness of 10 nm was formed by vapor-depositing aluminum on the plasma-treated surface using a resistance-heating method as a means for heating aluminum while introducing oxygen (PVD method).

Next, a barrier coating agent was prepared by the following procedure, and a barrier coat layer was formed on the surface of the aluminum oxide vapor deposition film.

A solution having a pH of 2.2 was prepared by mixing 385 g of water, 67 g of isopropyl alcohol, and 9.1 g of 0.5 N hydrochloric acid. Tetraethoxysilane (175 g) as a metal alkoxide was mixed to this solution while cooling to 10°C to obtain a solution A.

Polyvinyl alcohol (14.7 g) having a saponification degree of 99% or more and a polymerization degree of 2400 and serving as a water-soluble polymer, 324 g of water and 17 g of isopropyl alcohol were mixed to obtain a solution B.

The solution A and the solution B were mixed at a mass ratio of 5.5:4.5 to obtain a barrier coating agent. The surface of the vapor deposition film was coated with the barrier coating agent and dried at 100°C for 10 seconds. The thickness of the barrier coat layer formed by drying the barrier coating agent was 300 nm.

In this manner, the barrier films of Examples 1A to 12A and Comparative Example 1A were produced from the polymer films of Examples 1 to 10 and Comparative Example 1, respectively.

### [Production of laminates]

Using the barrier films of Examples 1A to 12A and Comparative Example 1A, laminates were produced by the following procedure.

A biaxially oriented polypropylene film having a thickness of 20 µm was prepared as a polypropylene base film. A urethane-based printing ink was applied to one surface of the polypropylene base film by a gravure roll coating method to form a printed layer. The dry thickness of the printed layer was 1 µm.

The printed layer and the surface of the barrier coat layer of such a barrier film were bonded to each other with a two-component curable polyurethane adhesive. The thickness of the adhesive layer formed by the two-component curable polyurethane adhesive was 2 µm.

Next, an unstretched polypropylene film having a thickness of 50 µm was prepared as a heat sealant film. The surface of the fourth resin layer of the barrier film and the heat sealant film were bonded to each other with a two-component curable polyurethane adhesive. The thickness of the adhesive layer formed by the two-component curable polyurethane adhesive was 2 µm.

In this way, laminates including the barrier films of Examples 1A to 12A and Comparative Example 1A were produced.

### [Examples 1B to 6B, 8B and 10B, and Comparative Example 1B]

A silicon oxide vapor deposition film was formed on the surface of the first resin layer of each of the polymer films of Examples 1 to 6, 8, and 10 and Comparative Example 1 by the following procedure.

The polymer film was introduced into an unwinding section in a depressurizable chamber having the unwinding section, a plasma treatment section, a film forming section, a winding section, and the like, and the pressure in the chamber was reduced. The surface of the first resin layer of the polymer film was subjected to a plasma pretreatment using argon gas while applying tension to the polymer film in a Roll-to-Roll manner using a plasma treatment apparatus; in the film forming section to which the polymer film was continuously transported, silicon oxide was vapor-deposited on the plasma-treated surface using an electron beam heating system as a heating means and silicon monoxide as a vapor deposition source to form a silicon oxide vapor deposition film having a thickness of 30 nm (PVD method).

In this manner, the barrier films of Examples 1B to 6B, 8B and 10B, and Comparative Example 1B were produced from the polymer films of Examples 1 to 6, 8, and 10, and Comparative Example 1, respectively.

### [Production of laminates]

Laminates were produced by the following procedure using the barrier films of Examples 1B to 6B, 8B, and 10B, and Comparative Example 1B.

A biaxially oriented polypropylene film having a thickness of 20 µm was prepared as a polypropylene base film. A urethane-based printing ink was applied to one surface of the polypropylene base film by a gravure roll coating method to form a printed layer. The dry thickness of the printed layer was 1 µm.

The printed layer and the surface of the silicon oxide vapor deposition film of such a barrier film were bonded to each other with a two-component curable polyurethane adhesive. The thickness of the adhesive layer formed by the two-component curable polyurethane adhesive was 2 µm.

Next, an unstretched polypropylene film having a thickness of 50 µm was prepared as a heat sealant film. The surface of the fourth resin layer of the barrier film and the heat sealant film were bonded to each other with a two-component curable polyurethane adhesive. The thickness of the adhesive layer formed by the two-component curable polyurethane adhesive was 2 µm.

In this way, laminates including the barrier films of Examples 1B to 6B, 8B and 10B, and Comparative Example 1B were produced.

### [Example 10C]

A carbon-containing silicon oxide vapor deposition film was formed on the surface of the first resin layer of the polymer film of Example 10 by the following procedure.

The polymer film was introduced into an unwinding section in a depressurizable chamber having the unwinding section, a plasma treatment section, a film forming section, a winding section, and the like, and the pressure in the chamber was reduced. The surface of the first resin layer of the polymer film was subjected to a plasma pretreatment using a mixed gas of argon and oxygen at a volume ratio of 1:1 while applying tension to the polymer film in a Roll-to-Roll manner using a plasma chemical vapor deposition apparatus (plasma CVD apparatus); in the film forming section to which the polymer film was continuously transported, a carbon-containing silicon oxide vapor deposition film having a thickness of 30 nm was formed on the plasma-treated surface (CVD method). The conditions for forming the vapor deposition film were as follows.

### (Forming conditions)

·Hexamethyldisiloxane:oxygen gas:helium = 1:10:10 (unit: slm)
·Electrode drum supply power: 22 kW
·Line speed: 40 m/min

In this way, the barrier film of Example 10C was produced from the polymer film of Example 10.

### [Production of laminate]

A laminate was produced by the following procedure using the barrier film of Example 10C.

A biaxially oriented polypropylene film having a thickness of 20 µm was prepared as a polypropylene base film. A urethane-based printing ink was applied to one surface of the polypropylene base film by a gravure roll coating method to form a printed layer. The dry thickness of the printed layer was 1 µm.

This printed layer and the surface of the carbon-containing silicon oxide vapor deposition film of the barrier film were bonded to each other with a two-component curable polyurethane adhesive. The thickness of the adhesive layer formed by the two-component curable polyurethane adhesive was 2 µm.

Next, an unstretched polypropylene film having a thickness of 50 µm was prepared as a heat sealant film. The surface of the fourth resin layer of the barrier film and the heat sealant film were bonded to each other with a two-component curable polyurethane adhesive. The thickness of the adhesive layer formed by the two-component curable polyurethane adhesive was 2 µm.

In this manner, a laminate including the barrier film of Example 10C was produced.

### [Evaluation of gas barrier properties before retort treatment]

Each of the laminates including the barrier films of Examples 1A to 12A and Comparative Example 1A, the laminates including the barrier films of Examples 1B to 6B, 8B and 10B, and Comparative Example 1B, and the laminate including the barrier film of Example 10C was cut out to obtain a test piece. Using the test piece, the oxygen transmission rate (unit: cc/(m²·day·atm)) and the water vapor transmission rate (unit: g/ (m²·day)) were measured by the following methods. The results are shown in Tables 2 to 4.

### (Oxygen transmission rate)

Using an oxygen transmission rate measuring apparatus (manufactured by MOCON, Inc., OX-TRAN2/20), the test piece was set so that the heat sealant film side of the test piece was the oxygen-supplying side, and the oxygen transmission rate was measured in an environment at a temperature of 23°C and a relative humidity of 90% RH in accordance with JIS K 7126-2:2006.

### (Water vapor transmission rate)

Using a water vapor transmission rate measuring apparatus (manufactured by MOCON, Inc., PERMATRAN-W 3/33), the test piece was set so that the heat sealant film side of the test piece was the water vapor supplying side, and the water vapor transmission rate was measured in an environment at a temperature of 40°C and a relative humidity of 90% RH in accordance with JIS K 7129-2:2019.

### [Evaluation of gas barrier properties after retort treatment at 121°C and 0.2 MPa for 30 minutes]

The laminates including the barrier films of Examples 1A to 12A and Comparative Example 1A were cut into an A4 size, folded to bisect the long sides so that the heat sealant film surfaces faced each other, and three sides including the folded portion were heat-sealed at a width of 7 mm to produce a three-side-sealed packaging bag. The three-side-sealed packaging bag was filled with tap water (200 mL), and sealed by heat-sealing the remaining one side to form a retort packaging bag filled with contents. Using steam, the retort packaging bag was subjected to a retort treatment at 121°C and 0.20 MPa for 30 minutes. The laminate was cut out from the retort packaging bag after the retort treatment, and the oxygen transmission rate and the water vapor transmission rate were measured in the same manner. The results are shown in Table 2.

### [Evaluation of gas barrier properties after retort treatment at 125°C and 0.25 MPa for 30 minutes]

The laminates including the barrier films of Examples 1A to 10A and Comparative Example 1A were cut into an A4 size, folded to bisect the long sides so that the heat sealant film surfaces faced each other, and three sides including the folded portion were heat-sealed at a width of 7 mm to produce a three-side-sealed packaging bag. The three-side-sealed packaging bag was filled with tap water (200 mL), and sealed by heat-sealing the remaining one side to form a retort packaging bag filled with contents. Using steam, the retort packaging bag was subjected to a retort treatment at 125°C and 0.25 MPa for 30 minutes. The laminate was cut out from the retort packaging bag after the retort treatment, and the oxygen transmission rate and the water vapor transmission rate were measured in the same manner. The results are shown in Table 2.

### [Evaluation of gas barrier properties after retort treatment at 130°C and 0.30 MPa for 60 minutes]

The laminates including the barrier films of Examples 1A and 5A, the laminates including the barrier films of Examples 1B to 6B, 8B and 10B, and Comparative Example 1B, and the laminate including the barrier film of Example 10C were cut into an A4 size, folded to bisect the long sides so that the heat sealant film surfaces faced each other, and three sides including the folded portion were heat-sealed at a width of 7 mm to produce a three-side-sealed packaging bag. The three-side-sealed packaging bag was filled with tap water (200 mL), and sealed by heat-sealing the remaining one side to form a retort packaging bag filled with contents. Using steam, the retort packaging bag was subjected to a retort treatment at 130°C and 0.30 MPa for 60 minutes. The laminate was cut out from the retort packaging bag after the retort treatment, and the oxygen transmission rate and the water vapor transmission rate were measured in the same manner. The results are shown in Tables 2 to 4.

**[Table 1]**

| Table 1 | | Example 1 | Example 2 | Example 3 | Example 4 | Example 5 | Example 6 | Example 7 | Example 8 | Example 9 | Example 10 | Example 11 | Example 12 | Comparative Example 1 | Comparative Example 2 | Comparative Example 3 | Comparative Example 4 |
|---|---|---|---|---|---|---|---|---|---|---|---|---|---|---|---|---|---|
| Formulation of first resin layer [mass%] | Polyamide A | 100 | | | | 80 | 60 | 60 | 50 | 70 | 50 | 100 | 100 | 20 | | | |
| | Polyamide B | | 30 | 50 | 70 | | | | | | | | | | | | |
| | Polyamide C | | 70 | 50 | 30 | | | | | | | | | | | | |
| | Polyamide D | | | | | 20 | | | | | | | | | | | |
| | Polyamide E | | | | | | 40 | | | | 50 | | | 80 | 100 | | |
| | Polyamide F | | | | | | | 40 | 50 | 30 | | | | | | 100 | |
| | Polyamide G | | | | | | | | | | | | | | | | 100 |
| Film thickness of first resin layer [µm] | | 0.7 | 0.7 | 0.7 | 0.7 | 0.7 | 0.7 | 0.7 | 0.7 | 0.7 | 0.7 | 0.4 | 1.5 | 0.7 | 0.7 | 0.7 | 0.7 |
| Differential scanning calorimetry (DSC) | Melting point [°C] | - | - | - | - | - | 222.5 | 184.3 | 189.6 | 194.6 | 225.8 | - | - | 226.4 | 224.0 | 196.5 | - |
| | Cold crystallization temperature [°C] | - | - | - | - | - | - | - | - | - | - | - | - | 153.3 | 167.4 | - | - |
| | Glass transition temperature [°C] | 124.1 | 107.6 | 112.9 | 128.1 | 134.2 | 107.3 | 74.2 | 71.1 | 107.3 | 98.0 | 124.1 | 124.1 | 90.6 | 84.5 | - | 158.2 |
| Film-forming properties | | A | A | A | A | A | B | B | B | B | B | A | B | B | C | C | D |
| Contact area ratio after heat treatment | | 93 | 89 | 91 | 89 | 91 | 85 | 84 | 82 | 87 | 84 | 95 | 84 | 56 | 43 | 18 | - |

**[Table 2]**

| Table 2 | | Example 1A | Example 2A | Example 3A | Example 4A | Example 5A | Example 6A | Example 7A | Example 8A | Example 9A | Example 10A | Example 11A | Example 12A | Comparative Example 1A |
|---|---|---|---|---|---|---|---|---|---|---|---|---|---|---|
| Formulation of first resin layer [mass%] | Polyamide A | 100 | | | | 80 | 60 | 60 | 50 | 70 | 50 | 100 | 100 | 20 |
| | Polyamide B | | 30 | 50 | 70 | | | | | | | | | |
| | Polyamide C | | 70 | 50 | 30 | | | | | | | | | |
| | Polyamide D | | | | | 20 | | | | | | | | |
| | Polyamide E | | | | | | 40 | | | | 50 | | | 80 |
| | Polyamide F | | | | | | | 40 | 50 | 30 | | | | |
| | Polyamide G | | | | | | | | | | | | | |
| Film thickness of first resin layer [µm] | | 0.7 | 0.7 | 0.7 | 0.7 | 0.7 | 0.7 | 0.7 | 0.7 | 0.7 | 0.7 | 0.4 | 1.5 | 0.7 |
| Type of vapor deposition film | | Aluminum oxide | Aluminum oxide | Aluminum oxide | Aluminum oxide | Aluminum oxide | Aluminum oxide | Aluminum oxide | Aluminum oxide | Aluminum oxide | Aluminum oxide | Aluminum oxide | Aluminum oxide | Aluminum oxide |
| Oxygen transmission rate [cc/(m²·day·atm)] | Before retort treatment | 0.3 | 0.2 | 0.2 | 0.3 | 0.3 | 0.4 | 0.4 | 0.3 | 0.3 | 0.4 | 0.4 | 0.3 | 1.2 |
| | After retort treatment at 121°C and 0.20 Mpa for 30 minutes | 0.4 | 0.3 | 0.3 | 0.4 | 0.6 | 0.7 | 0.8 | 0.7 | 0.5 | 0.6 | 0.6 | 0.5 | 2.3 |
| | After retort treatment at 125°C and 0.25 Mpa for 30 minutes | 0.5 | 0.6 | 0.4 | 0.5 | 0.7 | 0.7 | 1.6 | 1.8 | 1.5 | 0.7 | - | - | 2.8 |
| | After retort treatment at 130°C and 0.30 Mpa for 60 minutes | 6.1 | - | - | - | 6.7 | - | - | - | - | - | - | - | - |
| Water vapor transmission rate [g/(m²·day)] | Before retort treatment | 0.4 | 0.3 | 0.2 | 0.3 | 0.4 | 0.4 | 0.5 | 0.5 | 0.4 | 0.4 | 0.4 | 0.5 | 1.7 |
| | After retort treatment at 121°C and 0.20 Mpa for 30 minutes | 0.6 | 0.5 | 0.4 | 0.4 | 0.7 | 0.8 | 0.9 | 0.8 | 0.8 | 0.8 | 0.5 | 0.7 | 2.7 |
| | After retort treatment at 125°C and 0.25 Mpa for 30 minutes | 0.7 | 0.6 | 0.5 | 0.4 | 0.7 | 0.8 | 1.2 | 1.3 | 1.1 | 0.8 | - | - | 2.7 |
| | After retort treatment at 130°C and 0.30 Mpa for 60 minutes | 2.1 | - | - | - | 2.1 | - | - | - | - | - | - | - | - |

**[Table 3]**

| Table 3 | | Example 1B | Example 2B | Example 3B | Example 4B | Example 5B | Example 6B | Example 8B | Example 10B | Comparative Example 1B |
|---|---|---|---|---|---|---|---|---|---|---|
| Formulation of first resin layer [mass%] | Polyamide A | 100 | | | | 80 | 60 | 50 | 50 | 20 |
| | Polyamide B | | 30 | 50 | 70 | | | | | |
| | Polyamide C | | 70 | 50 | 30 | | | | | |
| | Polyamide D | | | | | 20 | | | | |
| | Polyamide E | | | | | | 40 | | 50 | 80 |
| | Polyamide F | | | | | | | 50 | | |
| | Polyamide G | | | | | | | | | |
| Film thickness of first resin layer [µm] | | 0.7 | 0.7 | 0.7 | 0.7 | 0.7 | 0.7 | 0.7 | 0.7 | 0.7 |
| Type of vapor deposition film | | Silicon oxide | Silicon oxide | Silicon oxide | Silicon oxide | Silicon oxide | Silicon oxide | Silicon oxide | Silicon oxide | Silicon oxide |
| Oxygen transmission rate [cc/(m²·day·atm)] | Before retort treatment | 0.3 | 0.2 | 0.2 | 0.3 | 0.3 | 0.4 | 0.3 | 0.4 | 0.6 |
| | After retort treatment at 130°C and 0.30 Mpa for 60 minutes | 0.5 | 0.4 | 0.4 | 0.5 | 0.9 | 0.6 | 0.8 | 0.5 | 1.6 |
| Water vapor transmission rate [g/(m²·day)] | Before retort treatment | 0.4 | 0.3 | 0.2 | 0.3 | 0.3 | 0.4 | 0.5 | 0.4 | 0.6 |
| | After retort treatment at 130°C and 0.30 Mpa for 60 minutes | 0.5 | 0.6 | 0.5 | 0.5 | 0.5 | 0.6 | 0.9 | 0.5 | 1.0 |

**[Table 4]**

| Table 4 | | Example 10C |
|---|---|---|
| Formulation of first resin layer [mass%] | Polyamide A | 50 |
| | Polyamide B | |
| | Polyamide C | |
| | Polyamide D | |
| | Polyamide E | 50 |
| | Polyamide F | |
| | Polyamide G | |
| Film thickness of first resin layer [µm] | | 0.7 |

| Type of vapor deposition film | | Carbon-containing silicon oxide |
|---|---|---|
| Oxygen transmission rate [cc/(m²·day·atm)] | Before retort treatment | 0.4 |
| | After retort treatment at 130°C and 0.30 Mpa for 60 minutes | 1.0 |
| Water vapor transmission rate [g/(m²·day)] | Before retort treatment | 0.3 |
| | After retort treatment at 130°C and 0.30 Mpa for 60 minutes | 1.9 |

As is clear from Table 1 above, the polymer films of Examples 1 to 12, in which the resin constituting the first resin layer did not exhibit a cold crystallization temperature and the glass transition temperature of the resin constituting the first resin layer was 155°C or lower, were excellent in film-forming properties, had a large contact area ratio after heat treatment, and were excellent in heat resistance.

As is clear from Table 2 above, the laminates including the barrier films of Examples 1A to 12A had lower oxygen transmission rates and lower water vapor transmission rates than the barrier film of Comparative Example 1A both before retort treatment and after retort treatment at 121°C and 0.20 MPa for 30 minutes, and were excellent in gas barrier properties.

As is clear from Table 2 above, the laminates including the barrier films of Examples 1A to 6A and 10A not containing an aliphatic chain polyamide in the first resin layer had lower oxygen transmission rates and water vapor transmission rates after retort treatment at 125°C and 0.25 MPa for 30 minutes, and were more excellent in gas barrier properties after the retort treatment under more severe conditions, as compared with the laminates including the barrier films of Examples 7A to 9A containing an aliphatic chain polyamide in the first resin layer.

As is clear from Tables 2 to 4 above, the laminates including the barrier films of Examples 1B to 6B, 8B and 10B including a silicon oxide vapor deposition film and the laminate including the barrier film of Example 10C including a carbon-containing silicon oxide vapor deposition film were lower in oxygen transmission rate after retort treatment at 130°C and 0.30 MPa for 60 minutes and more excellent in oxygen barrier properties after the retort treatment under even more severe conditions as compared with the barrier films of Examples 1A and 5A including an aluminum oxide vapor deposition film.

As is clear from Tables 2 to 4 above, the laminates including the barrier films of Examples 1B to 6B, 8B, and 10B having a silicon oxide vapor deposition film had a lower water vapor transmission rate after retort treatment at 130°C and 0.30 MPa for 60 minutes, and were more excellent in water vapor barrier properties after the retort treatment under even more severe conditions, as compared with the barrier films of Examples 1A and 5A having an aluminum oxide vapor deposition film.

### Reference Signs List

10 polymer film
11 first resin layer
12 second resin layer
13 third resin layer
14 fourth resin layer
15 vapor deposition film
16 barrier coat layer
17 adhesive layer
18 heat sealant film
19 polypropylene base film

## Claims

1. A polymer film comprising a first resin layer, a second resin layer, and a third resin layer in this order,
wherein the first resin layer constitutes one outermost layer of the polymer film,
the first resin layer includes a polyamide resin,
a resin constituting the first resin layer does not have a cold crystallization temperature,
a glass transition temperature of the resin constituting the first resin layer is 155°C or less,
the second resin layer includes an acid-modified product of polypropylene, and
the third resin layer includes homopolypropylene.

2. The polymer film according to claim 1, wherein the polyamide resin included in the first resin layer is of one type.

3. The polymer film according to claim 2, wherein a content of the polyamide resin in the first resin layer is 70 mass% or more.

4. The polymer film according to claim 1, wherein the polyamide resin included in the first resin layer is of two types, a first polyamide and a second polyamide,
the first polyamide is an aromatic polyamide or an alicyclic polyamide, and
the second polyamide is an aromatic polyamide, an alicyclic polyamide or an aliphatic chain polyamide.

5. The polymer film according to claim 4, wherein a content of the first polyamide in the first resin layer is 50 mass% or more and 95 mass% or less.

6. The polymer film according to claim 4 or 5, wherein a content of the second polyamide in the first resin layer is 5 mass% or more and 50 mass% or less.

7. The polymer film according to any one of claims 1 to 5, wherein the resin constituting the first resin layer has no melting point.

8. The polymer film according to any one of claims 1 to 5, wherein a content of polypropylene in the polymer film is 70 mass% or more.

9. The polymer film according to any one of claims 1 to 5, wherein a thickness of the third resin layer is largest among thicknesses of the first resin layer, the second resin layer, and the third resin layer, and
thicknesses of layers constituting the polymer film satisfy the following formulae (1) and (2): $Thickness of first resin layer \leq \left(Thickness of polymer film\right) / 10$ (1) $Thickness of second resin layer \leq \left(Thickness of polymer film\right) / 5$ (2)

10. The polymer film according to any one of claims 1 to 5, comprising a fourth resin layer on a side of the third resin layer opposite the second resin layer,
wherein the fourth resin layer includes a copolymer of propylene and an olefin other than propylene.

11. A barrier film comprising the polymer film according to any one of claims 1 to 5 and a vapor deposition film containing an inorganic oxide,
wherein the vapor deposition film is provided on a side of the first resin layer.

12. The barrier film according to claim 11, further comprising a barrier coat layer on a side of the vapor deposition film.

13. A laminate comprising the barrier film according to claim 11 and a heat sealant film.

14. The laminate according to claim 13, further comprising a polypropylene base film.

15. A packaging bag comprising the laminate according to claim 13.
